(19) Europäisches Patentamt
European Patent Office
Office européen des brevets

(11) Publication number: **0 304 136 B1**

(12) **EUROPEAN PATENT SPECIFICATION**

(45) Date of publication of patent specification: **29.06.94**

(51) Int. Cl.[5]: **G03F 7/031**, G03F 7/032, G03F 7/037

(21) Application number: **88201776.7**

(22) Date of filing: **18.08.88**

(54) **Novel photosensitive composition.**

(30) Priority: **19.08.87 JP 204276/87**

(43) Date of publication of application: **22.02.89 Bulletin 89/08**

(45) Publication of the grant of the patent: **29.06.94 Bulletin 94/26**

(84) Designated Contracting States: **CH DE FR GB IT LI NL**

(56) References cited:
**EP-A- 0 119 162**
**EP-A- 0 254 230**
**FR-A- 2 219 446**
**FR-A- 2 339 881**
**US-A- 3 558 309**
**US-A- 4 414 312**

(73) Proprietor: **Asahi Kasei Kogyo Kabushiki Kaisha**
**2-6, Dojimahama 1-chome**
**Kita-ku**
**Osaka-shi Osaka 530(JP)**

(72) Inventor: **Ai, Hideo**
**4-2, Asahi Kasei Naka Shataku**
**351-1, Samejima**
**Fuji-shi Shizuoka-ken(JP)**
Inventor: **Suga, Nobuhiko**
**921, Nishi-Apartment, 100**
**Kawanarijima**
**Fuji-shi Shizuoka-ken(JP)**
Inventor: **Ogitani, Satoshi**
**318, Goryou, 100, Kawanarijima**
**Fuji-shi Shizuoka-ken(JP)**

(74) Representative: **Smulders, Theodorus A.H.J., Ir. et al**
**Vereenigde Octrooibureaux**
**Nieuwe Parklaan 97**
**NL-2587 BN 's-Gravenhage (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

The present invention relates to a novel photosensitive composition. More specifically it relates to a novel photosensitive composition capable of forming fine patterns by a light of a wave length of 400 to 500 nm and transforming into a heat-resistant polymeric material.

Heretofore, making the most of their heat-resistant property and electric property, heat-resistant polymeric materials, typical of which are polyimides, are widely used as structural materials, printed circuit boards, heat-resistant insulating materials in the fields of electric, automobile, aeronautical, aerospace or nuclear power engineering.

On the other hand, photosensitive polymeric materials are widely used as coating materials and printing plates. Especially in recent years, making the most of their lithographic property, they have made a conspicuous achievement as fine processing materials including resists for making printed circuits and semiconductor elements and resists for metal plate etching. Recently extensive studies have been made to develop polymeric materials having these two useful functions, i.e., heat-resistance and photosensitivity for use as electronic or optical components. Such components include surface-protecting films such as junction coatings, passivation films, buffer coatings and -particle protecting films; insulation films for semiconductor devices such as insulation films between layers for multilayer circuits; molecular-oriented films for liquid crystal display devices; and insulation films for thin-film magnetic heads or for multilayer printed circuit boards [see, for example, Functional Materials, July, pages 9 - 19 (1983) and Photographic Science and Engineering, pages 303 - 309 (1979)].

DESCRIPTION OF THE PRIOR ART

Heretofore, as the heat-resistant photosensitive compositions are known compositions capable of forming a crosslinked structure by actinic irradiation which comprise a polymer prepared by introducing an active functional group such as a double bond-containing group onto the ester side chains of a polyamic acid which is a polyimide precursor, a photosensitizer and a polymerizable monomer (U.S. Patent No. 3,957,512 and U.S. Patent Re 30186). These compositions are basic compositions for heat-resistant polymeric materials for lithography, typical of which are so-called photosensitive polyimides. However, they are low in photosensitivity and not sufficient for practical purposes. As the composition which improves this defect is proposed a composition comprising a polyamic acid whose active functional group at its side chains is a methacrylate group or an acrylate group and an azide compound such as p-acetamidephenylsulfoneazide as the photopolymerization initiator (U.S. Patent 4,292,398). However, the photosensitivity of this composition is improved to some extent but still insufficient. On the other hand, in order to increase photosensitivity are proposed compositions comprising an ethylenically unsaturated compound and an oxime ester compound (U.S. Patent No. 3,558,309) or comprising a polyimide precursor and an oxime ester compound as the photopolymerization initiator (European Patent No. 025230A). These compositions, however, have either no or low photosensitivity to the g-line (wavelength : 436 nm) of a super high pressure mercury arc lamp. Also photosensitive compositions comprising a coumarin compound having a maximum absorption to a certain wave length (U.S. Patent Nos. 4,147,552), but these compositions have some photosensitivity to the g-line which is still insufficient for practical purposes. In addition, there are proposed photosensitive compositions comprising, as the main component, a mixture of a polyamic acid and an amine compound having an active functional group such as a double bond. However, they are solutions whose viscosity is very high and required to employ the solutions at low concentrations. When a spin coater and the like, which are widely employed for preparing a film on the surface of semiconductor elements, are employed, it is difficult to form a thick film from them. Further, when these compositions are left to stand after coating and drying, cracks are disadvantageously easily formed by moisture absorption due to the component capable of forming an ion bond contained therein.

EP-A-0 119 162 discloses a photosensitive composition, comprising a prepolymer having photopolymerizable ethylenically unsaturated bonds, which prepolymer may also be used according to the present invention, and a compound having a terminal ethylenically unsaturated group, such as an acrylic or methacrylic acid ester, an allylether or a allylester of a polyol. As a photoinitiator metallocene is used.

FR-A-2 219 446 discloses a photosensitive composition, comprising a prepolymer obtained by polyaddition or polycondensation of polyfunctional carbocyclic and/or heterocyclic compounds, which bear at least two functional groups suitable for addition or condensation and organic groups which react upon radiation. As a photoinitiator Michler's Keton, benzoin ether, tert.butyl-9,10-anthraquinone, 1,2-benzo-9,10-anthraquinone and 4,4-bis (diethylamino) benzophenone are mentioned.

Typically, the photosensitive compositions disclosed in the above described prior art are coated as solutions on a substrate, dried, exposed to actinic light such as ultra violet rays through a photomask and developed with a suitable developing solvent to remove unexposed portions by dissolution. Then the images thus obtained are subjected to the treatment at high temperatures to be transformed into a heat-resistant structure such as an imide structure and simultaneously to vaporize the volatile components such as the side chain of the polyamic acid, the crosslinking chain and the initiator, resulting in a heat-resistant film of the images. According to the conventional technology, however, when such photosensitive compositions are exposed to actinic light by using a stepper of g-line (wavelength : 436 nm) of a super high pressure mercury arc lamp which is an exposure device most popularly employed in a step of the production of LSI devices, the photosensitivity of the compositions is nil or very low and the exposing time required for hardening becomes long. Thus such compositions may be said to have a great disadvantage in view of the efficient application of such an expensive exposure device and the throughput of products.

Further, the combination of an oxime compound having a specific structure and a photosensitizer having absorption in the region of specific wave lengths is found to increase the photosensitivity of the composition by the inventors of the present invention. This combination, however, has no or insufficient photosensitivity to an actinic light of a wave length of 400 to 500 nm.

It is an object of the present invention to provide a photosensitive composition having high photosensitivity to an actinic light of a wave length of 400 to 500 nm, in particular, to the exposure to actinic light by a g-line stepper, the composition being capable of forming heat-resistant images, patterns or films.

Other objects of the present invention will become apparent from the following description.

According to the present invention there is provided a photosensitive composition capable of forming fine patterns by an actinic light of a wave length of 400 to 500 nm which comprises :

(a) a polymer having recurring units represented by the formula

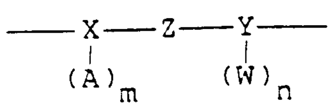

[I]

wherein

X is a (2 + m) valent $C_{6-30}$ carbocyclic group or heterocyclic group ;

Y is a (2 + n) valent $C_{6-30}$ carbocyclic group or heterocyclic group ;

Z is

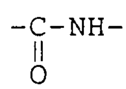 , 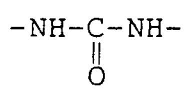

or

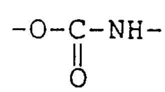 ;

A is -COOR* or $-COO^{\ominus}R^{**\oplus}$ wherein each of R* and R** is a group having a carbon-carbon double bond ;

W is a group capable of reacting with the carbonyl group of A to form a ring on heating , selected from $-NH_2$ and

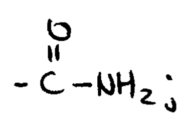

A and W are arranged in ortho- or peri-position to z ;

m is 1 or 2 ; and
n is 0, 1 or 2 ,

(b) 1 to 20 % by weight, based on the weight of polymer (a), of a compound having a terminal ethylenically unsaturated group ;

(c) 0.1 to 20 % by weight, based on the weight of polymer (a), of an oxime ester compound represented by the formula

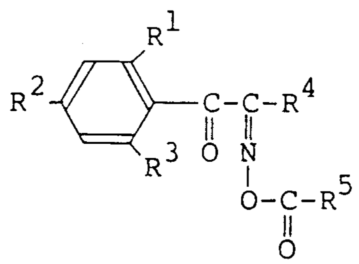

[II]

wherein

each of $R^1$, $R^2$ and $R^3$ is a hydrogen atom, a $C_{1-6}$ alkyl group, a $C_{1-6}$ alkoxy group or a nitro group;

$R^4$ is $C_{7-11}$ aromatic acyl group, a $C_{2-7}$ $R^4$ is a $C_{7-11}$ aromatic acyl group, a $C_{2-7}$ aliphatic acyl group, a $C_{2-7}$ alkoxycarbonyl group, a $C_{6-10}$ aromatic sulfonyl group or a $C_{1-6}$ aliphatic sulfonyl group ; and

$R_5$ is a $C_{1-6}$ alkyl group, a $C_{1-6}$ alkoxy group, a $C_{6-10}$ aromatic group or a $C_{6-10}$ aryloxy group ; and

(d) 0.01 to 10 % by weight, based on the weight of polymer (a), of a coumarin compound having a wave length of the absorption peak of 330 to 550 nm

The polymer used as component (a) in the photosensitive composition of the present invention having recurring units represented by the above described formula [I], wherein X is a tri- or tetra-valent $C_{6-30}$ carbocyclic or heterocyclic group. Examples of X are a tri- or tetra-valent aromatic ring such as a benzene ring and a toluene ring; a tri- or tetra-valent condednsed polycyclic ring such as a naphthalene ring and an anthracene ring; a tri- or tetra-valent heterocyclic group such as pyridine, methylpyridine and thiophene; and a group having the following formula

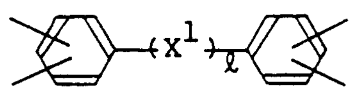

[Ia]

wherein

ℓ is zero or one ; and

$X^1$ is

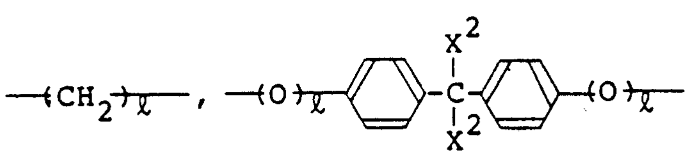

wherein ℓ is zero or one,

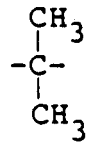 , 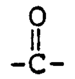 ,

-S- ,

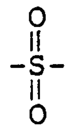 ,

-O- or

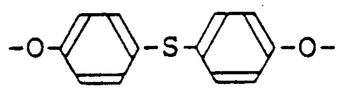 ;

and

X[2] is $-CH_3$ or $-CF_3$.

Of these groups as X, preferred are

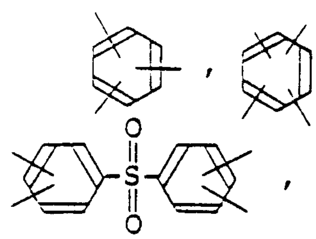 , , ,

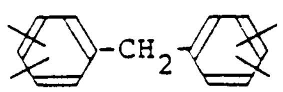 , 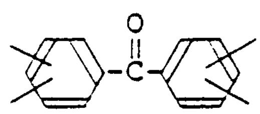 ,

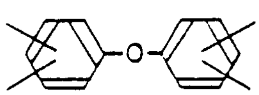 , 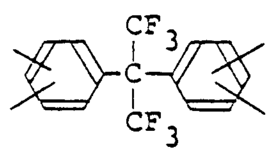 and 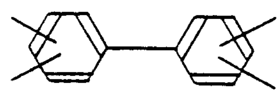 .

Y in formula [I] is a di-, tri-or tetra-valent $C_{6-30}$ carbocyclic or heterocyclic group. Examples of Y are a di-, tri- or tetra-valent $C_{10-18}$ condensed polycyclic ring such as a naphthalene ring and an anthracene ring ; a di-, tri- or tetra-heterocyclic ring derived from pyridine and imidazole and the groups represented by the following formulae

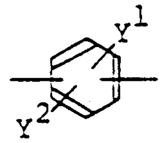

[Ib]

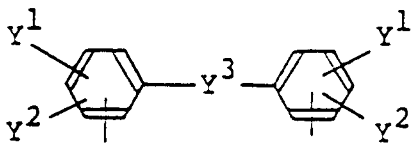

[Ic]

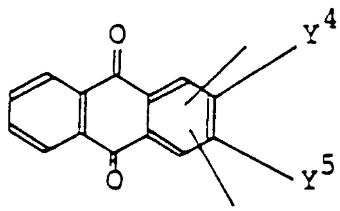

[Id]

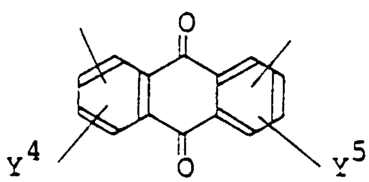

[Ie]

and

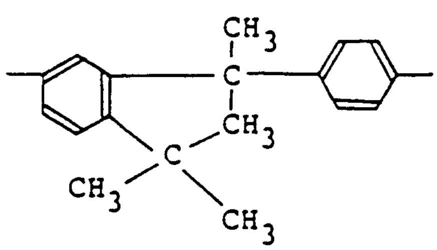

[If]

wherein

$Y^1$ and $Y^2$ each is a hydrogen atom, $-CH_3$, $-C_2H_5$, $-CH(CH_3)_2$, $-OCH_3$, $-COOH$, $-NO_2$, $-CONH_2$, $-NH_2$, a halogen atom or $-SO_3H$ ;

$Y^3$ is

$$-(CH_2)_p-$$

wherein p is zero or one;

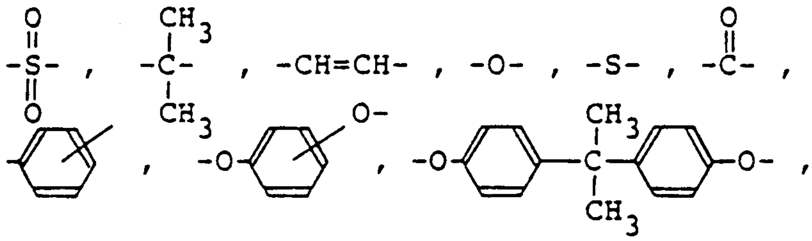

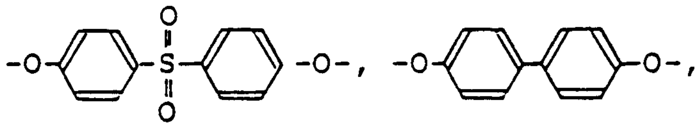

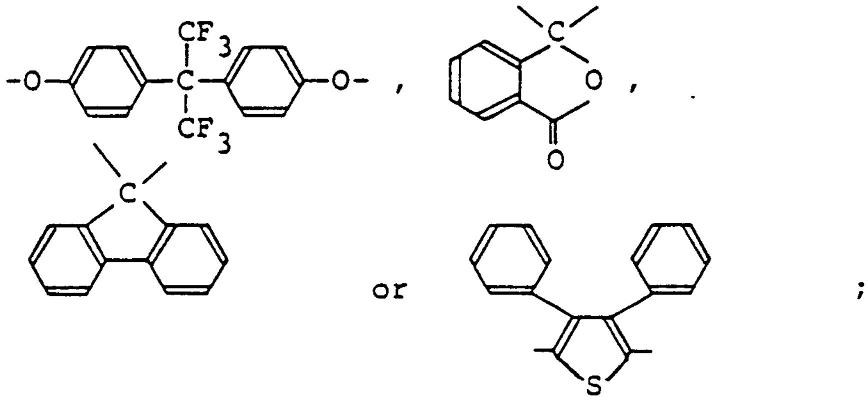

or

;

$Y^4$ and $Y^5$ each is a hydrogen atom, -CN, a halogen atom, $-CH_3$, $-OCH_3$, $-SO_3H$, $-NH_2$, -COOH or $-CONH_2$.

Of these groups as Y preferred are groups represented by formula [Ib] and [Ic].

Z in formula [I] is

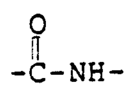 , 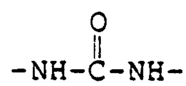

or

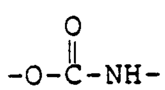 .

Of these group preferred is

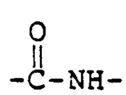

which is capable of transforming into an imide ring in the heat treatment.

R* in A of formula [I] is a group having a carbon-carbon double bond. Such groups include the ones represented by the following formulae

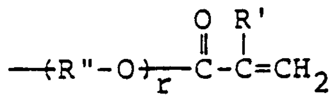

[Ig]

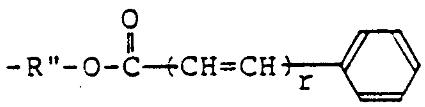

[Ih]

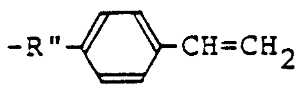

[Ii]

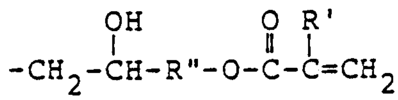

[Ij]

$-R''-CH=CH_2$

[Ik]

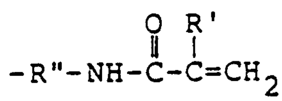

[Iℓ]

wherein

R′ is a hydrogen atom or a methyl group;
R″ is a $C_{1-3}$ alkylene group; and
r is one or two.

Exemplary groups [Ig] to [Iℓ] include

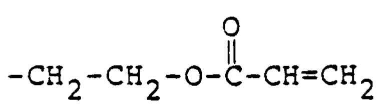 , 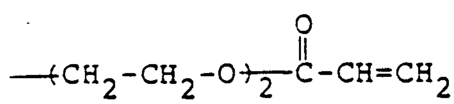 ,

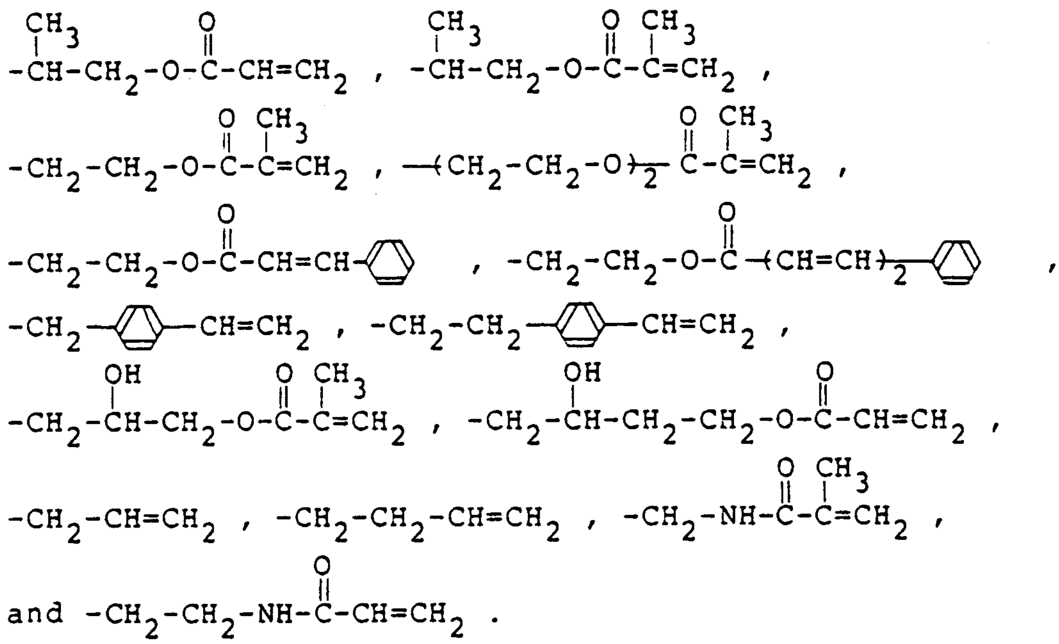

and

Of these groups preferred are

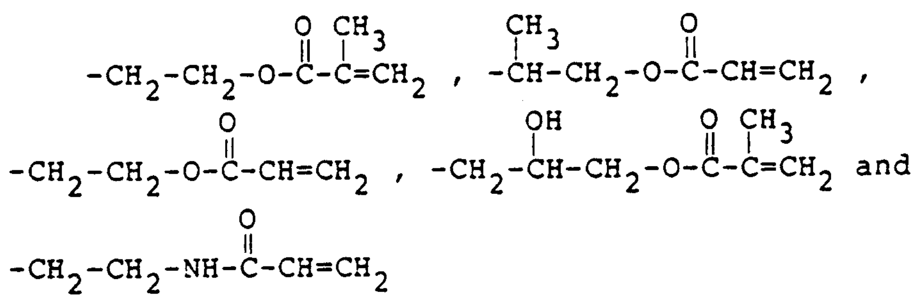

and

in view of the photosensitivity and storage stability of the polymer.

When A in formula [I] is $-COO^{\ominus}R^{**\oplus}$, $R^{**\oplus}$ is a group having a carbon-carbon double bond represented by the formula

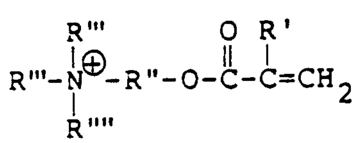

[Im]

wherein

R′ and R″ are the same as defined in formulae [Ig] to [Iℓ];

R‴ is a methyl group or an ethyl group; and

R⁗ is a hydrogen atom or a methyl group.

Preferred examples of such groups are

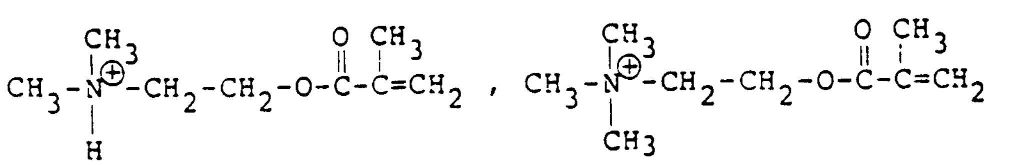

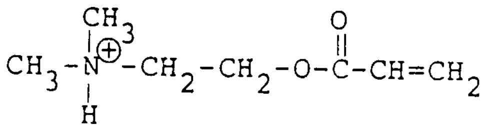 and 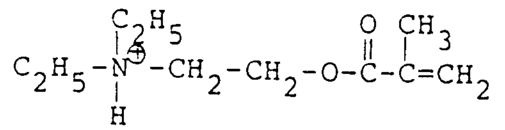 .

W is a group capable of reacting with the carbonyl group of A to form a ring in the heat treatment, selected from $-NH_2$ and

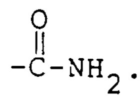

The compound having a terminal ethylenically unsaturated group which is employed as component (b) in the photosensitive composition of the present invention not only improves the photosensitivity of the composition but also imparts sufficient adhesiveness to the composition. The terminal ethylenically unsaturated group of the compound is represented by the formula,

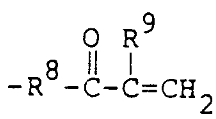

[IV]

wherein

$R^8$ is -O- or -NH- and $R^9$ is a hydrogen atom or a methyl group,

and a preferred terminal ethylenically unsaturated group is an acryloxy group, i.e., $R^8$ is -O- and $R^9$ is a hydrogen atom in formula [IV] and preferred compounds have a plurality of acryloxy groups. The compounds having at least one terminal ethylenically unsaturated group are typically low molecular weight monomeric compounds and oligomers having a molecular weight of 60 to 1,000.

Exemplary compounds having a terminal ethylenically unsaturated group include 2-ethylhexyl acrylate or methacrylate, 2-hydroxyethyl acrylate or methacrylate, carbitol acrylate or methacrylate, tetrahydrofurfuryl acrylate or methacrylate, isobornyl acrylate or methacrylate, 1,6-hexanediol diacrylate or methacrylate, neopentyl glycol diacrylate or dimethacrylate, ethylene glycol diacrylate or dimethacrylate, tetraethylene glycol diacrylate or dimethacrylate, nonaethylene glycol diacrylate or dimethacrylate, N-vinylpyrrolidone, methylenebisacrylamide, methylenebismethacrylamide and N-methylol acrylamide or methacrylamide, polyethylene glycol diacrylate or dimethacrylate (molecular weight 100 - 1,000), pentaerythritol triacrylate or trimethacrylate, dipentaerythritol hexaacrylate or hexamethacrylate, tetramethylolpropane tetraacrylate or tetramethacrylate, N-vinylpyrrolidone, methylenebisacrylamide, methylenebismethacrylamide, N-methylolacrylamide and N-methylolmethacrylamide.

The oxime ester compound (c) which is employed as a photoinitiator in the photosensitive composition of the present invention is represented by

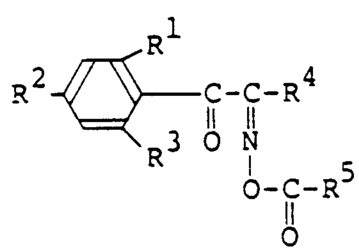

[II]

wherein

each of $R^1$, $R^2$ and $R^3$ is a hydrogen atom, a $C_{1-6}$ alkyl group, a $C_{1-6}$ alkoxy group or a nitro group;

$R^4$ is a $C_{7-11}$ aromatic acyl group, a $C_{2-7}$ aliphatic acyl group, a $C_{2-7}$ alkoxycar-

bonyl group, a $C_{6-10}$ aromatic sulfonyl group or a $C_{1-6}$ aliphatic sulfonyl group ; and

$R_5$ is a $C_{1-6}$ alkyl group, a $C_{1-6}$ alkoxy group, a $C_{6-10}$ aromatic group or a $C_{6-10}$ aryloxy group.

Preferred $R^1$, $R^2$ and $R^3$ are each a hydrogen atom, a methyl group, an ethyl group, a methoxy group, an ethoxy group and a nitro group. Preferred $R^4$ are a benzoyl group, a toluoyl group, an acetyl group, a propionyl, an ethoxycarbonyl group, a benzenesulfonyl group, a toluenesulfonyl group, a methanesulfonyl group and an ethanesulfonyl group. Preferred $R^5$ are an ethyl group, butyl groups, a methoxy group, an ethoxy group, a phenyl group, tolyl groups and a phenoxy group.

Exemplary oxime esters include

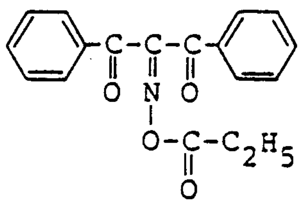 , 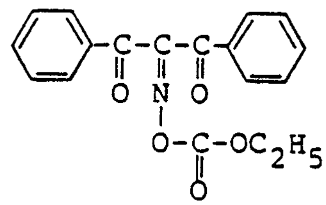

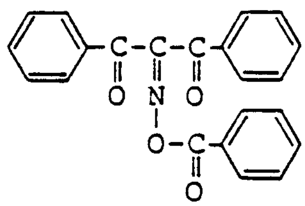 , 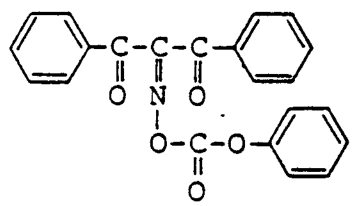

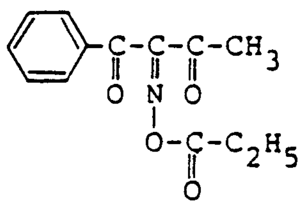 , 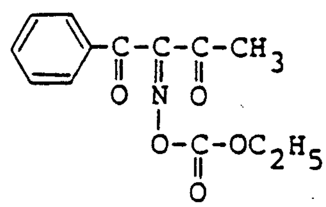

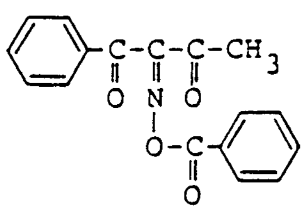 , 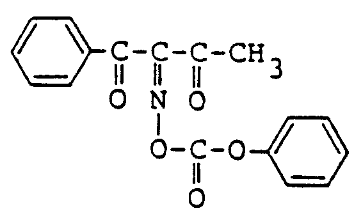

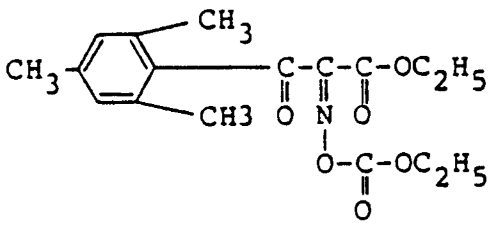 , 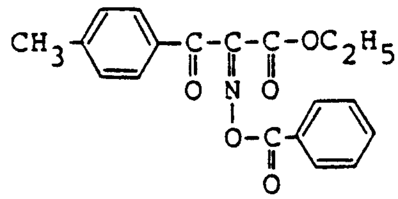

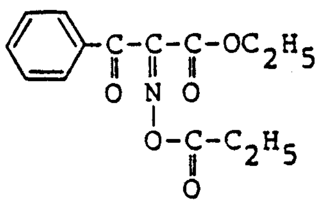 , 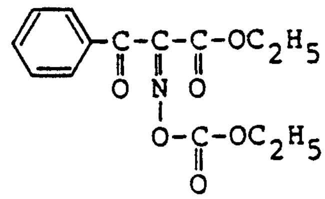

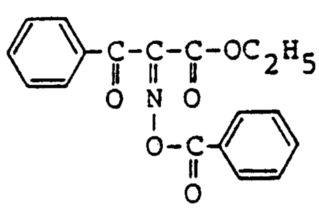 , 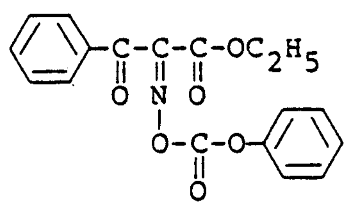

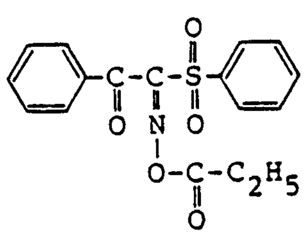 , 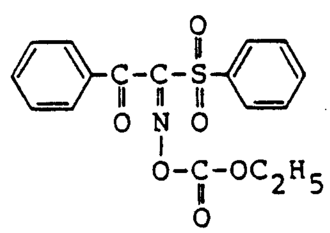

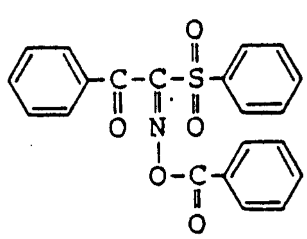 , 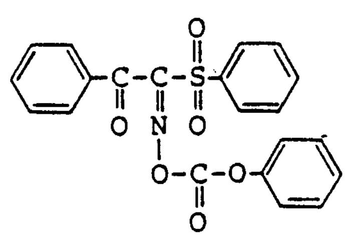

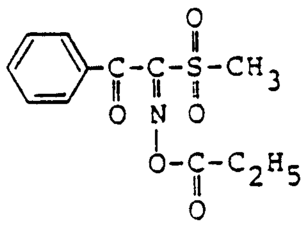
,
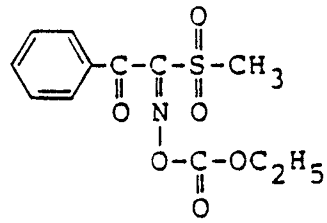

,
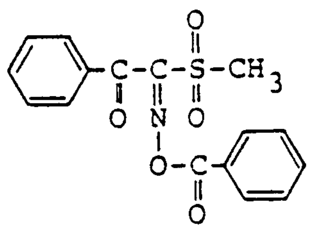
,
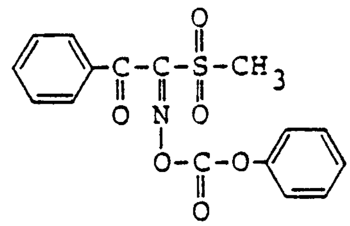

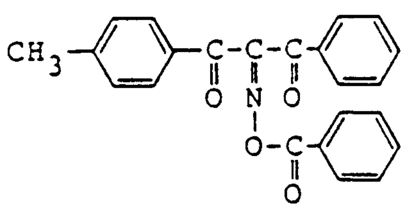
,
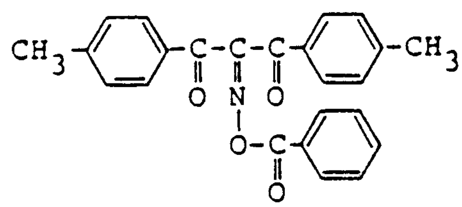

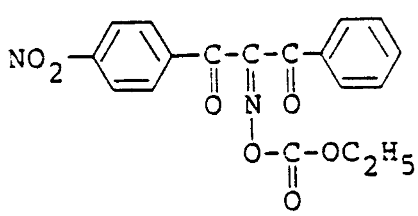
,
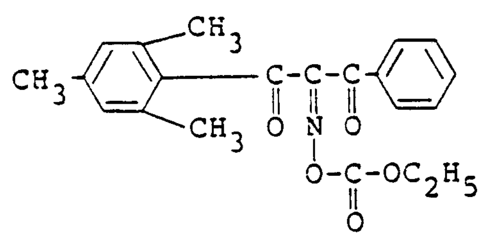

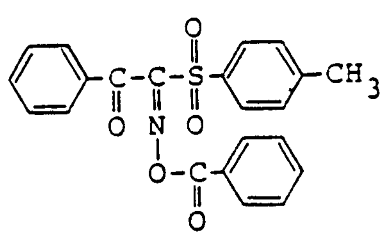
,
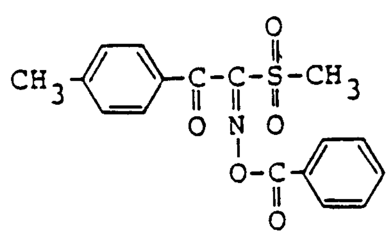

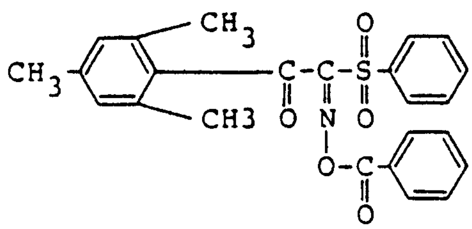 , 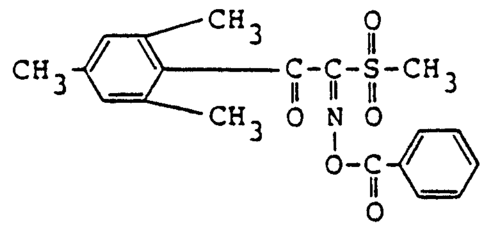

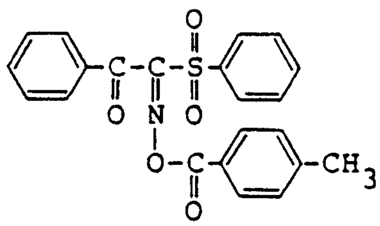 , 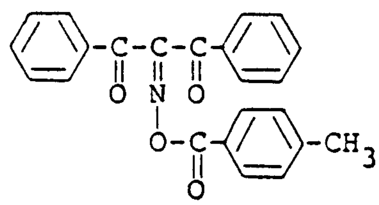

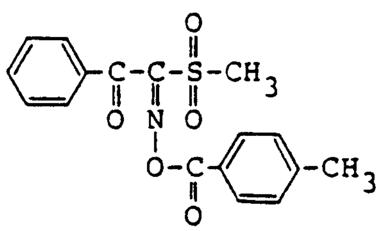 , 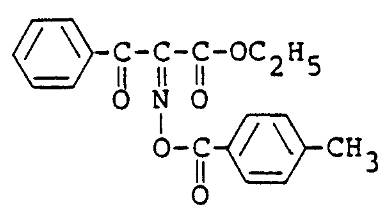

These oxime ester compounds may be employed singly or in combination.

The oxime ester compound which is employed as component (c) can be prepared by firstly converting a compound to an oxime compound according to the method described in ORGANIC SYNTHESIS, Vol. 40, pp 21 ~ 23 and ORGANIC SYNTHESIS Collective Vol. 3, pp 513 ~ 516 and secondly reacting the oxime compound with an acid chloride or an acid anhydride.

The coumarin compound (d) which is employed as a photosensitizer in the photosensitive composition of the present invention is represented by the formula

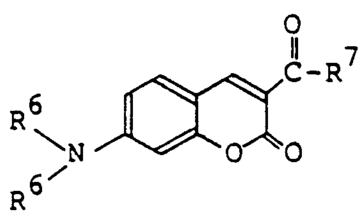

[III]

wherein

$R^6$ is a methyl group or an ethyl group; and

$R^7$ is a $C_{1-7}$ alkoxy group.

Preferred $R^7$ are a methoxy group, an ethoxy group, an n-propoxy group, an isopropoxy group, an n-butoxy group, an isobutoxy group, a tert-butoxy group and a benzyloxy group.

Exemplary coumarin compounds include

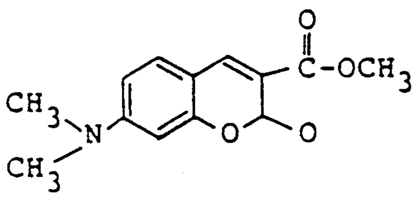

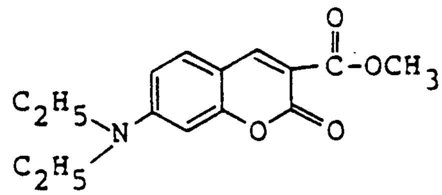

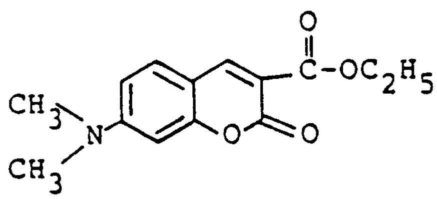

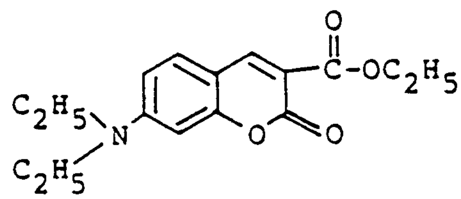

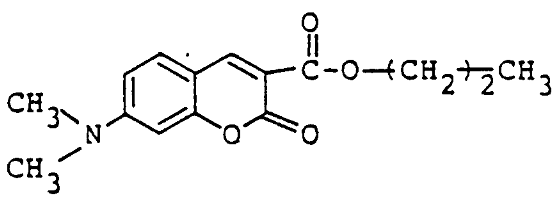

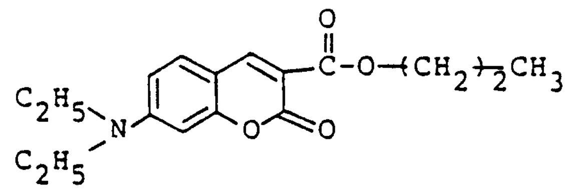

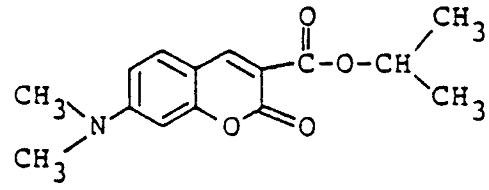

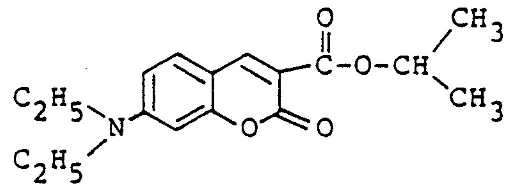

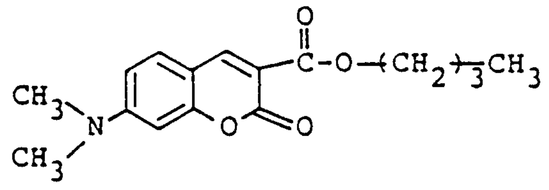

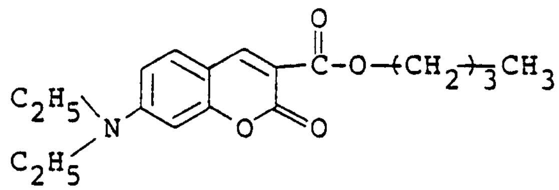

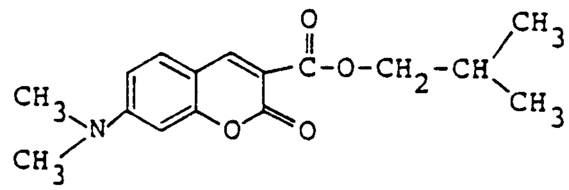

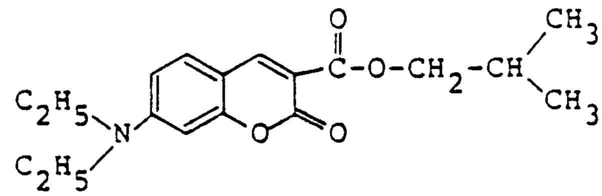

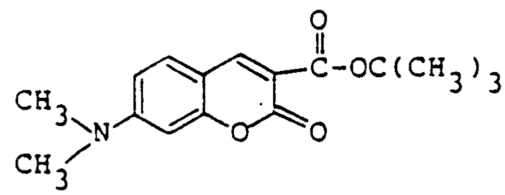

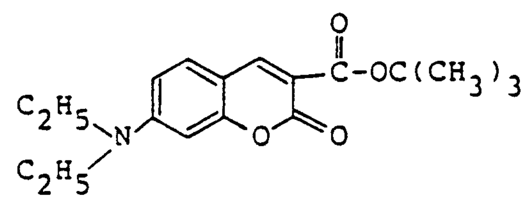

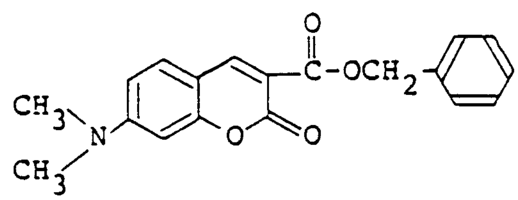

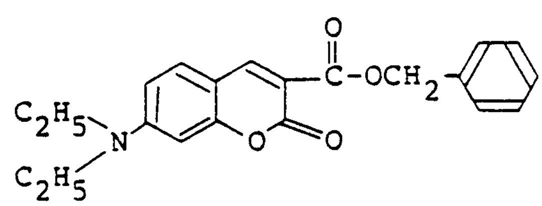

These coumarin compounds may be employed singly or in combination.

The coumarin compound which is employed as compound (d) can be prepared by the ring-forming reaction of a dialkylaminosalycyl aldehyde and a β-ketonic ester according to the methods described in ORGANIC REACTIONS Vol. 15, 204 ~ 273.

The coumarin compounds of the present invention can increase the photosensitivity of the photosensitive composition of the present invention to g-line in a great extent compared to the conventional coumarin compounds such as 7-dialkylamino-3-ketocoumarins, 7-dialkylamino-4-substituted coumarins and 3,3'-carbonylbis(7-dialkylaminocoumarins). The photosensitivity of these conventional coumarin compounds to g-line is less than half of that of the coumarin compounds of the present invention and accordingly is insufficient for practical purposes.

The amount of the compound having a terminal ethylenically unsaturated group used as component (b) in the photosensitive composition of the present invention is 1 to 20 % by weight, preferably 1 to 10 % by weight based on the weight of the polymer as component (a). The amount of the oxime ester compound used as component (c) is 0.1 to 20 % by weight, preferably 1 to 15 % by weight based on the weight of the polymer as component (a). When the amount is less than 0.1 % by weight, the photosensitivity is

insufficient. On the other hand, amounts of more than 20 % by weight decrease the film or membrane properties after the heat treatment. The amount of the coumarin compound used as component (d) is 0.01 to 10 % by weight, preferably 0.05 to 5 % by weight based on the weight of the polymer. When the amount is less than 0.01 % by weight, the photosensitivity is insufficient. On the other hand, amounts of more than 10 % by weight decrease the photosensitivity.

The addition of an aromatic compound represented by the formula

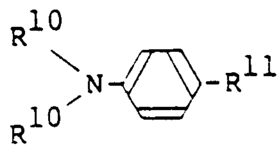

[V]

wherein

$R^{10}$ is a $C_{1-3}$ alkyl group, a $C_{1-3}$ hydroxyalkyl group or a morpholino group; $R^{11}$ is a $C_{1-3}$ alkyl group, a $C_{2-5}$ alkylcarbonyl group or a $C_{7-10}$ arylcarbonyl group,

further increases the sensitivity to an actinic light having a wave length of 400 to 500 nm. Of these compounds represented by formula [V], preferred compounds are 4-dimethylaminoacetophenone, 4-morpholinoacetophenone, 4-dimethylaminobenzophenone, 4-morpholinobenzophenone, N-phenyldiethanolamine, N-p-tolyldiethylamine and N-p-tolyldiethanolamine.

In addition, the use of a mercapto-containing aromatic heterocyclic compound in the photosensitive composition can further improve the photosensitivity of the composition. Exemplary mercapto-containing aromatic heterocyclic compounds include 2-mercaptobenzimidazole, 2-mercaptobenzothiazole, 1-phenyl-5-mercapto-1H-tetrazole, 2-mercapto-4-phenylthiazole, 2-amino-5-mercapto-1,3,4-thiazole, 2-mercaptoimidazole, 2-mercapto-5-methyl-1,3,4-thiazole, 5-mercapto-1-methyl-1H-tetrazole, 2,4,6-trimercapto-s-triazine, 2-dibutylamino-4,6-dimercapto-s-triazine 2,5-dimercapto-1,3,4-thiadiazole, 5-mercapto-1,3,4-thiadiazole, 1-ethyl-5-mercapto-1,2,3,4-tetrazole, 2-mercapto-6-nitrothiazole, 2-mercaptobenzoxazole, 4-phenyl-2-mercaptothiazole, mercaptopyridine, 2-mercaptoquinoline, 1-methyl-2-mercaptoimidazole and 2-mercapto-β-naphthothiazole. The amount of the mercapto-containing aromatic heterocyclic compound employed is typically at most 10 % by weight, preferably at most 5 % by weight, based on the weight of the polymer as component (a).

If necessary or desired, a silane compound represented by the formula

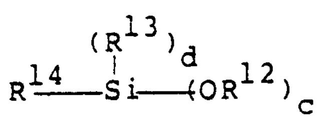

[IV]

wherein

each of $R^{12}$ and $R^{13}$ is a $C_{1-6}$ alkyl group; $R^{14}$ is a hydrocarbon group which may have an oxygen atom, a nitrogen atom or a sulfur atom; and c is 3 and d is 0 or c is 2 and d is 1,

can be added to the photosensitive composition of the present invention or pre-coated on a substrate. This silane compound can improve the adhesiveness of the interface between the photosensitive composition of the present invention and silicon or an inorganic insulating film or membrane as a substrate. Exemplary silane compounds include γ-aminopropylmethyldimethoxysilane, γ-aminopropylmethyldiethoxysilane, γ-aminopropyltrimethoxysilane, γ-aminopropyltriethoxysilane, N-(β-aminoethyl)-γ-aminopropylmethyldimethoxysilane, N-(β-aminoethyl)-γ-aminopropylmethyldiethoxysilane, N-(β-aminoethyl)-γ-aminopropyltrimethoxysilane, N-(β-aminoethyl)-γ-aminopropyltriethoxysilane, γ-glycidoxypropylmethyldimedthoxysilane, γ-glycidoxypropylmethyldiethoxysilane, γ-mercaptopropylmethyldimethoxysilanesilane, γ-mercaptopropylmethyldiethoxysilane, 3-methacryloxypropyldimethoxymethylsilane, 3-methacryloxypropyldiethoxymethylsilane, 3-methacryloxypropyltrimethoxysilane, 3-methacryloxypropyltriethoxysilane, dimethoxymethyl-3-piperidinopropylsilane, diethoxymethyl-3-piperidinopropylsilane, N-(3-dimethoxylmethylsilylpropyl)-succinimide, N-(3-diethoxymethylsilylpropyl)succinimide, phenyldimethoxymethylsilane and phenyldiethoxymethylsilane.

When the silane compound is used, its amount is typically 0.05 to 10 % by weight, preferably 0.1 to 5 % by weight, based on the weight of the polymer as component (a).

Furthermore, in order to improve the storage stability of the solution of the photosensitive composition according to the present invention, a polymerization inhibitor can be added to the composition. Exemplary polymerization inhibitors include hydroquinone, N-nitrosodiphenylamine, p-tert-butylcatechol, phenothiazine, N-phenylnaphthylamine and 2,6-di-tert-butyl-p-methylphenol. The amount of the polymerization inhibitor employed is typically at most 5 % by weight, preferably at most 0.5 % by weight, based on the weight of the polymer as component (a).

The polymer used as component (a) in the photosensitive composition can be prepared by the condensation polymerization or the addition polymerization of a compound represented by the formula

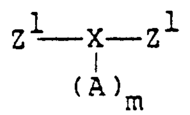

[VII]

and a compound represented by the formula

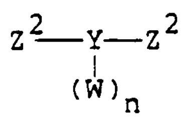

[VIII]

In formulae [VII] and [VIII], $Z^1$ is -COOH, -COCℓ, -NCO, $-NH_2$ or -OH; $Z^2$ is -COCℓ, -COOH, -NCO or $-NH_2$; and X, Y, m and n are the same as defiend above.

Z is formed by the reaction of $Z^1$ and $Z^2$ in the condensation polymerization or the addition of the compound of formula [VII] and the compound of formula [VIII]. In this reaction preferred combinations of $Z^1$ and $Z^2$, types of Z formed and ring structures formed in the heat treatment of the resultant polymers are set forth in Table 1.

Table 1

| No. | $Z^1$ | $Z^2$ | Z | Ring structure |
|---|---|---|---|---|
| 1 | -COOH | $-NH_2$ | 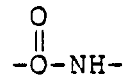 | imide ring |
| 2 | -COCℓ | -do- | -do- | -do- |
| 3 | -COCℓ | -NCO | -do- | -do- |
| 4 | -NCO | -COOH | -do- | ——— |
| 5 | $-NH_2$ | -NCO | 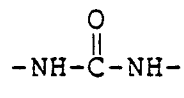 | quinazoline dione ring |
| 6 | $-NH_2$ | -COOH | 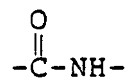 | ——— |
| 7 | -OH | -NCO | 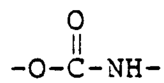 | oxazine dione ring |

The polymer as component (a) can be prepared by reacting one of the compounds represented by the formulae

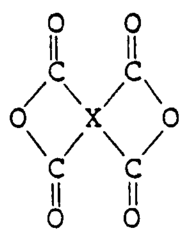 [IX] , 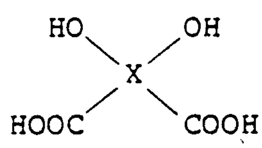 [X]

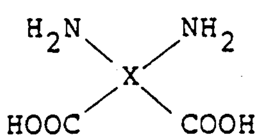 [XI]

wherein X is the same as defined above,
with a compound of formula [VIII] wherein $Z^2$ is -NCO or $-NH_2$, reacting the carboxyl group of the resultant compound with an epoxy compound represented by the formula

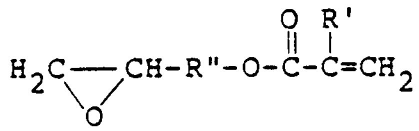

[XII]

wherein R′ and R″ are the same as defined above,
or an amine compound represented by the formula

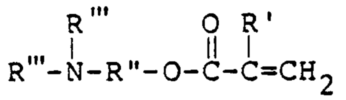

[XIII]

wherein

R′ and R″ are the same as defined above; and

R‴ is a methyl group or an ethyl group.

or a quaternary ammonium salt represented by the formula

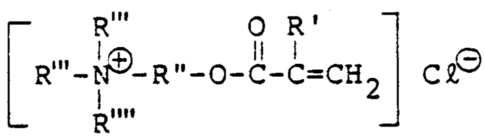

[XIV]

wherein

R′, R″ and R‴ are the same as defined above; and

R⁗ is a hydrogen atom or a methyl group.

The compound of formula [VII] wherein $Z^1$ is -COOH, for example, can be prepared by the ring-opening reaction of an acid dianhydride represented by formula [IX] as described above and an alcohol represented by the formula

R*OH [XV]

wherein R* is the same as defined above.

Exemplary acid dihydrides of formula include pyromellitic dianhydride, 3,3′,4,4′-benzophenonetetracarboxylic dianhydride, 3,3′,4,4′-diphenyltetracarboxylic dianhydride, 3,3′,4,4′-diphenylethertetracarboxylic dianhydride, 3,3′,4,4′-diphenylsulfonetetracarboxylic dianhydride, 2,3,6,7-naphthalenetetracarboxylic dianhydride, thiophene-2,3,4,5-tetracarboxylic dianhydride and 2,2-bis(3,4-biscarboxyphenyl)propane dianhydride.

Exemplary alcohols of formula [XV] include 2-hydroxyethyl acrylate or methacrylate, 2-hydroxypropyl acrylate or methacrylate, allyl alcohol and ethylene glycol monoallylether.

The use of pyridine or dimethylpyridine in the reaction of the acid dianhydride of formula [IX] and the alcohol of formula [XV] accelerates the reaction.

Of the combinations of the compound of formula [VII] and the compound of formula [VIII], preferred is a combination of the formula [VII] wherein $Z^1$ is -COOH or -COCℓ and the compound of formula [VIII] wherein $Z^2$ is $-NH_2$.

In this combination, exemplary compounds of formula [VIII] wherein $Z^2$ is $-NH_2$ include 4,4′-diaminodiphenylether, 4,4′-diaminobiphenyl, 2,4-diaminotoluene, 4,4′-diaminobenzophenone, 4,4-diaminodiphenylsulfone, 9,10-bis(4-aminophenyl)anthracene, 4,4′-diaminodiphenylmethane,p-phenylenediamine, m-phenylenediamine, 1,5-diaminonaphthalene, 3,3′-dimethoxy-4,4′-diaminobiphenyl, 3,3′-dimethyl-4,4′-diaminobiphenyl, o-toluidinesulfone, 2,2-bis(4-aminophenoxyphenyl)propane, bis(4-aminophenoxyphenyl)sulfone, bis(4-aminophenoxyphenyl)sulfide, 1,4-bis(4-aminophenoxy)benzene, 1,3-bis-(4-aminophenoxy)benzene, 3,4′-diaminodiphenylether, 9,9-bis(4-aminophenyl)fluorene, 3,3′-diaminodiphenylsulfone, 4,4′-di(3-aminophenoxy)diphenylsulfone, 4,4′-diaminobenzanilide and 3,4′-diaminodiphenylether.

The reaction of the compound of formula [VII] wherein $Z^1$ is -COOH and the compound of formula [VIII] wherein $Z^2$ is $-NH_2$ can be carried out by using a carbodiimide such as dicyclohexylcabodiimide as the dehydration condensing agent. Suitable solvents for this reaction are aprotic polar solvents including, for example, N,N-dimethylformamide, hexamethylphosphorotriamide, N-methylpyrrolidone, N,N-dimethylacetamide, tetrahydrofuran and γ-butyrolactone. The reaction is carried out at a temperature of -20 °C to 80 °C, preferably -10 °C to 30 °C, for 1 to 100 hours, preferably 2 to 24 hours, under continuous stirring. The method for preparing polyamides with the use of a carbodiimide is described in U.S. Patent No. 4,645,823 and this method can be advantageously employed in this invention. According to this method the molecular weight of the polymers can be controlled by varying the mol ratio of the compound of formula [VII] wherein $Z^1$ is -COOH and the compound of formula [VIII] wherein $Z^2$ is $-NH_2$. Further, when the reaction is carried out by using an excess amount of one of these two compounds, it is preferred to add a capping agent for remaining terminals. As the capping agent preferred are alcohols such as methanol and ethanol and amines such as butylamint and aniline when the compound of formula [VII] is in excess. In separating the polymer formed from the reaction mixture, it is preferred to add an alcohol little by little to the reaction mixture. The purification of the polymer is carried out by dissolving the solid polymer thus separated in a solvent such as tetrahydrofuran and adding the solution little by little to water to precipitate a polymer.

The compound of formula [VII] wherein $Z^1$ is -COCℓ, can be prepared by the reaction of the half ester of the compound of formula [VII] wherein $Z^1$ is -COOH, and thionyl chloride or phosphorus pentachloride.

In the reaction of the compound of formula [VII] wherein $Z^1$ is COCℓ and the compound of formula [VIII] wherein $Z^2$ is $-NH_2$, the same solvent as used in the reaction of the compound of formula [VII] wherein $Z^1$ is -COOH and the compound of formula [VIII] wherein $Z^2$ is $-NH_2$, can be employed. However, when tetrahydrofuran or γ-butyrolactone is employed, it is necessary to employ an amine such as pyridine and triethylamine as the dehydrochlorining agent. In separating the polymer formed from the reaction mixture it is preferred to add the reaction mixture little by little to a large amount of water. The purification of the polymer is carried out by pulverizing the solid polymer thus separated and washing the pulverized polymer with water or by repeating the steps of dissolving the solid polymer in an organic solvent and adding the solution to water to precipitate a polymer.

The photosensitive composition of the present invention is made into a solution by dissolving all the components in a solvent and then coated on a substrate. In this instance, the substrate may be pre-coated with the above described silane compound in order to enhance the adhesion of the photosensitive composition to the substrate.

The solvent which can be preferably employed in the present invention is a polar solvent having a not too high boiling point. Such solvents include N,N-dimethylformamide, N-methylpyrrolidone, N,N-dimethylacetamide, diglyme, isobutyl acetate, cyclopentanone and mixtures thereof. Further, a solvent such as an alcohol, an aromatic hydrocarbon, an ether, a ketone and an ester can be added to the above described solvent in such an amount as not to precipitate the components of the photosensitive composition.

The solution thus obtained is filtered and then coated on a substrate by means of a spin coater, a bar coater, a blade coater, a roll coater or a spray or by screen printing or dipping the substrate in the solution, and then dried in air, with heating and/or in vacuum.

The substrate which can be preferably employed in the present invention is of a heat resistant material such as a metal, a glass, a silicon semiconductor, a chemical compound semiconductor, a metal oxide insulator and silicon nitride. Also a copper-lined glass epoxy laminate can be employed when the heat treatment is not conducted.

As the photosensitive composition of the present invention has high photosensitivity to an actinic light of a wave length of 400 to 500 nm, light sources having spectral lines in the region of this wave length are preferably employed. Exemplary light sources include a super high pressure mercury arc lamp and a xenon-mercury arc lamp which have g-line (wave length 436 nm) and h-line (wave lengh 405 nm), Ar ion laser and He-Cd laser which have several oscillating wave lengths in the region of a wave length of 400 to 500 nm. Of these light sources, a g-line stepper which is an exposure device selectively using the g-line of a super high pressure mercury arc lamp for exposure is preferably employed.

It is preferred that the exposure to an actinic light of a wave length of 400 to 500 nm is conducted in a nitrogen atmosphere.

After exposure the development is carried out by removing unexposed portions of the photosensitive composition with a developper by dipping or spraying. Preferred is a developer capable of compoletely removing the unexposed parts within a suitable period of time. Such developers are aprotic polar solvents

including γ-butyrolactone, N-methylpyrrolidone, N-acetyl-2-pyrrolidone, N,N-dimethylformamide, N,N-dimethylacetamide, dimethyl sulfoxide, hexamethylphosphorotriamide and N-benzyl-2-pyrrolidone. The solvents can be used alone or in combination with a second solvent. Such second solvents are alcohols including ethanol and isopropanol; aromatic hydrocarbons including toluene and xylene; ketones including methylethyl ketone and methylisobutyl ketone; esters including ethyl acetate and methyl propionate; and ethers including tetrahydrofuran and dioxane.

Further, it is preferred to rinse the developed images or patterns with the above described second solvent immediately after the development.

After drying, the images or patterns thus obtained are transformed into polymers having heat-resistant structural units of imide rings, oxazine dione rings and quinazoline dione rings in the heat treatment at a temperature of 150 °C to 450 °C.

The photosensitive composition of the present invention has, as its advantage, high sensitivity to an actinic light of a wave length of 400 to 500 nm, in particular, a g-line stepper for exposure. This originates from the use of the oxime ester compound (c) as the photoinitiator and the coumarin compound (d) as the photosensitizer in combination. The photosensitivity of the photosensitive composition of the present invention is at least two times higher that of the conventional photosensitive composition which uses a 3-ketocoumarin compound as the photosensitizer instead of the coumarin compound (d). Also the photosensitive composition of the present invention has remarkably improved lithographic properties which are important for the the properties of a photoresist. Thus the photosensitive composition of the present invention has ideal properties for a photoresist exhibiting high resolution in a small exposure dose. Furthermore, the photosensitive composition of the present invention has excellent storage stability for a long period of time and does not show the occurrence of infavorable gelation, cracks and surface films at coating and drying. Thus, when the photosensitive composition of the present invention is employed for the preparation of insulation films between layers for semiconductor elements and surface-protecting films, the process can be shortened and fine processing can be rendered easy due to the above described advantages, which can improve to a great extent the productivity of LSI devices in their complicated production steps.

The following Examples are given to illustrate the present invention more specifically. However, it should be understood that the invention is in no way limited by these Examples.

The polymers, compounds having a terminal ethylenically unsaturated group, oxime ester compounds, coumarin compounds, aromatic amine compounds, mercapto-containing heterocyclic compounds, silane compounds and photopolymerization initiators which were employed in the following examples are set forth in Table 2 to 11.

With respect to the index showing the molecular weight of the polymers as component (a) of the photosensitive composition of the present invention, viscosity number was employed. The viscosity number can be obtained by the following way. In 100 ml of N-methyl-2-pyrrolidone was dissolved 1 g of a polymer to give a solution having a concentration of 0.01 g/ml which is designated as C. In an Ostwald's viscometer were placed 10 ml of this solution and the dropping time of the solution is measured and designated as $\eta$ [sec]. Separately, 10 ml of N-methyl-2-pyrrolidone alone were placed in the Ostwald's viscometer and the dropping time of the solution is measured and designated as $\eta_o$ [sec]. The viscosity number is defined by the following equation and is calculated from it.

$$\text{Viscosity Number} = \frac{1}{C}\left(\frac{\eta - \eta_o}{\eta_o}\right)$$

Syntheses of (1-1) Polymers in Table 2

In a 500 ml separable flask were placed 21.8 g of pyromellitic dianhydride, 27.0 g of 2-hydroxyethyl methacrylate and 100 ml of γ-butyrolactone, and to the mixture were added 17.0 g of pyridine under cooling with ice with stirring. Stirring of the mixture thus obtained was continued for 16 hours at 20 °C, and then 40 ml of a γ-butyrolactone solution containing 41.2 g of dicyclohexylcarbodiimide was added thereto over a period of 10 minutes under cooling with ice, followed by the addition of 35 ml of a γ-butyrolactone suspension containing 17.2 g of 4,4′-diaminodiphenylether over a period of 20 minutes. After this mixed reaction solution was stirred at 20 °C for 3 hours, 5 ml of ethanol was added thereto and stirring was

continued for one hour. The reaction solution thus obtained was filtered and the filtrate was added dropwise to 5 ℓ of ethanol with vigorous stirring. The precipitates formed were isolated by filtration by means of suction and dried under vacuum to give a polymer of yellowish powder. This polymer is designated as P-1.

In the same manner as described above, the polymers designated as P-2 to P-7 were prepared by using the alcohols, acid anhydrides and amines as set forth in Table 2.

Table 2

(1-1) Polymers

| Polymer No. | Starting Materials | | | Viscosity Number |
|---|---|---|---|---|
| | Alcohol (g) | Acid anhydride (g) | Amine (g) | |
| P-1 | 2-HEMA*1 (27.0) | PMDA*3 (21.8) | 4,4'-Diaminodiphenyl-ether (17.2) | 15.4 |
| P-2 | - do - | BTDA*4 (32.2) | - do - | 14.3 |
| P-3 | - do - | PMDA (10.9)<br>BTDA (16.1) | - do - | 15.1 |
| P-4 | - do - | PMDA (6.5)<br>BTDA (22.5) | - do - | 15.0 |
| P-5 | 2-HPA*2 (27.0) | PMDA (10.9)<br>BTDA (16.1) | - do - | 14.9 |
| P-6 | - do - | PMDA (6.5)<br>BTDA (22.5) | 4,4'-Diamino-3,3'-biphenyldicarbox-amide (23.8) | 14.4 |
| P-7 | - do - | - do - | 2,5-Diaminobenzamide (13.3) | 14.6 |

*1 2-HEMA : 2-Hydroxyethyl methacrylate *2 2-HPA : 2-Hydroxypropyl acrylate
*3 PMDA : Pyromellitic dianhydride
*4 BTDA : 3,3',4,4'-Benzophenonetetracarboxylic dianhydride

Syntheses of (1-2) Polymers in Table 3

In a 500 ml separable flask were placed 24.0 g of 3,3′-dicarboxy-4,4′-diaminobiphenyl and 120 g of N,N-dimethylacetamide, and to the mixture were added 100 g of an N,N-dimethylacetamide solution containing 25.0 g of 4,4′-diphenylmethane diisocyanate under cooling with ice with stirring. After this reaction solution was stirred 20 °C for 2 hours, 30.0 g of glycidyl methacrylate, 3.0 g of benzyldimethylamine and 0.3 g of hydroquinone were added thereto. The reaction mixture solution was heated at a temperature of 50 °C to 60 °C for 23 hours with stirring and then added dropwise to 5ℓ of ethanol with vigorous stirring. The precipitates formed were isolated by filtration by means of suction and dried under vacuum at 20 °C to give a polymer of yellowish powder. This polymer is designated at P-8.

In the same manner as described above, the polymer designated at P-9 was prepared by using the epoxy compound, isocyanate and amine as set forth in Table 3.

Syntheses of (1-3) Polymers in Table 4

In a 500 ml separable flask were placed 24.0 g of 2,5-dihydroxybenzoic acid and 160 g of N-methyl-2-pyrrolidone, and to the mixture were added 140 g of a N-methyl-2-pyrrolidone solution containing 25.0 g of 4,4′-diphenylmethane diisocyanate with stirring. The reaction mixture solution thus obtained was heated at a temperature of 30 °C to 40 °C for 12 hours with stirring. After 2 ml of ethanol were added to the reaction solution and the mixture solution was stirred at 20 °C for 2 hours, 27.7 g of dimethylaminoethyl methacrylate were added thereto, and the mixture solution thus obtained was stirred for 2 hours to give a polymer dope. The polymer thus obtained was designated as P-10.

In the same manner as described above, an N-methyl-2-pyrrolidone solution containing the polymer designated at P-11 was prepared using the alcohol, isocyanate and amine as set forth in Table 4.

Table 3

(1-2) Polymers

| Polymer No. | Starting Materials: Epoxy Compound (g) | Starting Materials: Isocyanate (g) | Starting Materials: Amine (g) | Viscosity Number |
|---|---|---|---|---|
| P-8 | Glycidyl methacrylate (30.0) | 4,4'-Diphenylmethane diisocyanate (25.0) | 3,3'-Dicarboxy-4,4'-diaminobiphenyl (24.0) | 15.5 |
| P-9 | - do - | Tolylene-2,4-diisocyanate (17.4) | - do - | 15.3 |

Table 4

(1-3) Polymers

| Polymer No. | Starting Materials: Alcohol (g) | Starting Materials: Isocyanate (g) | Starting Materials: Amine (g) | Viscosity Number |
|---|---|---|---|---|
| P-10 | 2,5-Dihydroxybenzoic acid (24.0) | 4,4'-Diphenylmethane diisocyanate (25.0) | Dimethylaminoethyl methacrylate (27.7) | 17.7 |
| P-11 | - do - | Tolylene-2,4-diisocyanate (17.4) | - do - | 18.5 |

Table 5

| Compound Having A Terminal Ethylenically Unsaturated Group | |
|---|---|
| No. | Compound |
| M-1 | Trimethylolpropane triacrylate |
| M-2 | Tetraethyleneglycol diacrylate |
| M-3 | Methylenebisacrylamide |

Table 6

Oxime Ester Compound

| No. | Compound |
|---|---|
| K-1 | 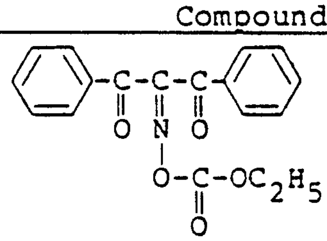 |
| K-2 | 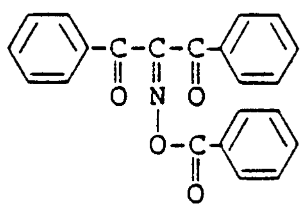 |
| K-3 | 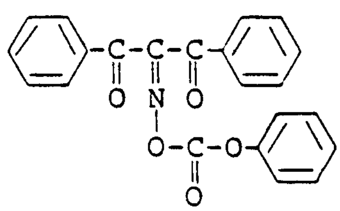 |

Table 6 (-continued)

Oxime Ester Compound

| No. | Compound |
|---|---|
| K-4 | 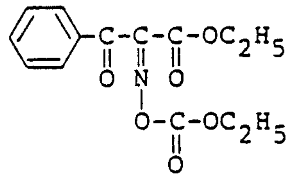 |
| K-5 | 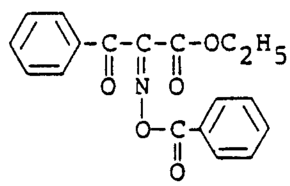 |
| K-6 | 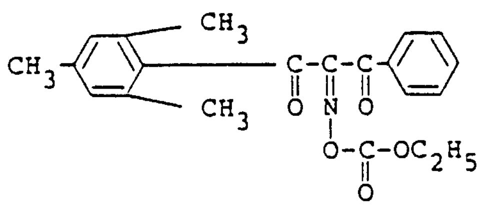 |
| K-7 | 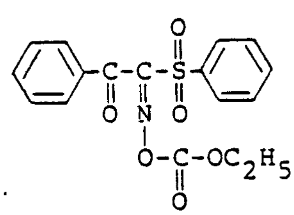 |
| K-8 | 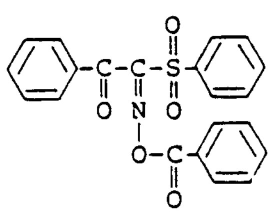 |

Table 7

Coumarin Compound

| No. | Compound |
|---|---|
| B-1 | 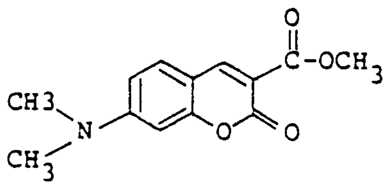 |
| B-2 | 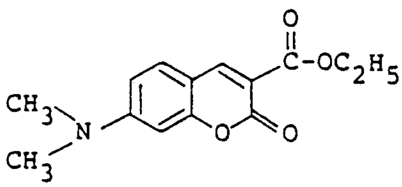 |
| B-3 | 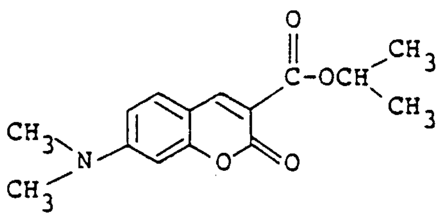 |
| B-4 | 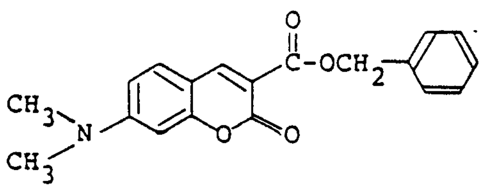 |
| B-5 | 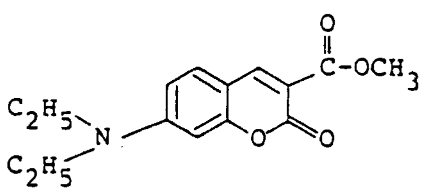 |
| B-6 | 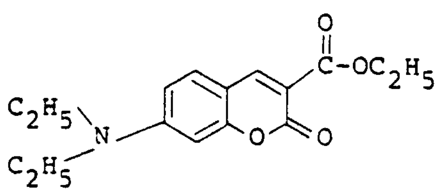 |

Table 8

| Aromatic Amine Compound | |
|---|---|
| No. | Compound |
| S-1 | N-Phenyldiethanolamine |
| S-2 | N-p-Tolyldiethanolamine |
| S-3 | 4-Morpholinobenzophenone |

Table 9

| Mercapto-Containing Aromatic Heterocyclic Compound | |
|---|---|
| No. | Compound |
| A-1 | 2-Mercaptobenzimidazole |
| A-2 | 1-Phenyl-5-mercapto-1H-tetrazole |
| A-3 | 2-Mercaptobenzthiazole |

Table 10

| Silane Compound | |
|---|---|
| No. | Compound |
| D-1 | 3-Methacryloxypropyltrimethoxysilane |
| D-2 | 3-Methacryloxypropyldimethoxymethylsilane |
| D-3 | Diethoxy-3-glycidoxypropylmethylsilane |
| D-4 | 3-Methacryloxypropyltriethoxysilane |

Table 11

| Polymerization Inhibitor | |
|---|---|
| No. | Compound |
| Z-1 | N-Nitrosodiphenylamine |
| Z-2 | p-tert-Butylcatechol |
| Z-3 | 2,6-Di-tert-butyl-p-methylphenol |

Examples 1 to 41

To 100 parts by weight of the polymer as set forth in Table 12 were added the compound having a terminal ethylenically unsaturated group, the oxime ester compound, the coumarin compound and, if indicated, the aromtic amine compound, the mercapto-containing heterocyclic compound, the silane compound and the polymerization inhibitor in an amount by parts by weight as set forth in Table 12, and the mixture was dissolved in 130 parts by weight of N-methylpyrrolidone to give a solution. The solution thus obtained was spin-coated on a silicon wafer at 2,000 r.p.m. for 30 seconds and dried in air at 70 °C for 90 minutes to give a uniform coating having a thickness of about 20 µm.

Then the coated silicon wafer was exposed through a photomask bearing a test pattern to g-line using a g-line stepper (manufactured by Canon Koki K.K., "FPA 1550 MII", illuminance at the surface of the silicon wafer : 520 mW/cm$^2$). Then the exposed silicon wafer was left to stand at 20 °C for one hour, developed with a mixed solution of N-methylpyrrolidone and xylene of a volume ratio of 1 : 1, rinsed with isopropyl

alcohol and dried. The photosensitivity was obtained from the exposure dose which clearly resolved the line and space part of 20 µm in the test pattern. The photosensitivity is higher with decreased exposure doses.

The results thus obtained are set forth in Table 12.

Examples 42 to 45

To an N-methylpyrrolidone solution containing 100 parts by weight of polymer P-10 or P-11 were added the compound having a terminal ethylenically unsaturated group, the oxime ester compound, the coumarin compound, the aromatic amine compound, the mercapto-containing heterocyclic compound, the silane compound and the polymerization inhibitor in an amount by parts by weight as set forth in Table 12 to give a solution. The solution thus obtained was spin-coated on a silicon wafer at 700 r.p.m. for 30 seconds and dried in air at 70 °C for 90 minutes to give a uniform coating having a thickness of 15 µm with polymer P-10 or 13 µm with polymer P-11. In the same manner as in Examples 1 to 41 the exposure to g-line, development, rinsing and drying were conducted and the photosensitivity was obtained from the exposure dose which clearly resolved the line and space part of 16 µm in the test pattern.

The results thus obtained are set forth in Table 12.

Table 12

| Example No. | Polymer No. | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 1 | P-1 | M-1 (6) | K-1 (3) | B-1 (0.4) | S-1 (2) | A-1 (2) | D-1 (2) | Z-1 (0.1) | 520 |
| 2 | -do- | -do- | -do- | -do- | -do- | -do- | -do- | - | -do- |
| 3 | -do- | -do- | -do- | -do- | -do- | -do- | - | - | -do- |
| 4 | -do- | -do- | K-1 (8) | -do- | -do- | - | D-1 (2) | Z-1 (0.1) | 572 |
| 5 | -do- | -do- | K-1 (6) | -do- | - | A-1 (2) | -do- | -do- | 520 |
| 6 | -do- | M-1 (10) | K-1 (10) | -do- | - | - | -do- | -do- | 572 |
| 7 | -do- | -do- | -do- | -do- | - | - | - | - | -do- |
| 8 | -do- | M-1 (3) | K-1 (5) | B-1 (0.6) | S-1 (2) | A-1 (2) | D-1 (2) | Z-1 (0.1) | 520 |

Table 12 (-continued)

| Example No. | Polymer No. | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 9 | P-1 | M-1 (10) | K-1 (1.5) | B-1 (0.6) | S-1 (2) | A-1 (2) | D-1 (2) | Z-1 (0.1) | 520 |
| 10 | -do- | M-1 (6) | K-1 (3) | B-2 (0.4) | -do- | -do- | D-2 (2) | -do- | -do- |
| 11 | -do- | M-2 (6) | -do- | B-3 (0.4) | -do- | A-2 (2) | D-3 (2) | -do- | -do- |
| 12 | -do- | -do- | -do- | -do- | -do- | -do- | -do- | - | -do- |
| 13 | -do- | -do- | -do- | -do- | -do- | -do- | - | - | -do- |
| 14 | -do- | -do- | K-1 (8) | -do- | -do- | - | - | - | 572 |
| 15 | -do- | M-2 (10) | K-1 (10) | -do- | - | - | - | - | -do- |
| 16 | -do- | M-2 (6) | K-1 (3) | B-4 (0.4) | S-1 (2) | A-2 (2) | D-2 (2) | Z-1 (0.1) | 520 |

Table 12 (-continued)

| Example No. | Polymer No. | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 17 | P-1 | M-3 (6) | K-1 (3) | B-5 (0.4) | S-1 (2) | A-3 (2) | D-2 (2) | Z-1 (0.1) | 520 |
| 18 | -do- | -do- | -do- | B-6 (0.4) | -do- | -do- | -do- | -do- | -do- |
| 19 | P-2 | M-2 (6) | K-2 (3) | -do- | S-2 (2) | A-2 (2) | -do- | -do- | 572 |
| 20 | -do- | -do- | -do- | -do- | -do- | -do- | - | - | -do- |
| 21 | P-3 | -do- | -do- | -do- | -do- | -do- | D-2 (2) | Z-1 (0.1) | -do- |
| 22 | -do- | -do- | -do- | -do- | -do- | -do- | - | - | -do- |
| 23 | P-4 | -do- | -do- | -do- | -do- | -do- | D-2 (2) | Z-1 (0.1) | -do- |
| 24 | -do- | -do- | -do- | -do- | -do- | -do- | - | - | -do- |

Table 12 (-continued)

| Example No. | Polymer No. | Compound having a terminal ethylenically unsaturated grou (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 25 | P-5 | M-2 (6) | K-2 (3) | B-6 (0.4) | S-2 (2) | A-2 (2) | D-2 (2) | Z-2 (0.2) | 520 |
| 26 | P-4 | M-1 (6) | -do- | B-3 (0.4) | S-3 (2) | -do- | -do- | Z-1 (0.1) | 572 |
| 27 | -do- | -do- | K-3 (3) | -do- | -do- | -do- | -do- | -do- | 520 |
| 28 | -do- | -do- | K-4 (3) | -do- | -do- | -do- | -do- | -do- | 572 |
| 29 | -do- | -do- | K-5 (3) | -do- | -do- | -do- | -do- | -do- | -do- |
| 30 | -do- | -do- | K-6 (3) | -do- | -do- | -do- | -do- | -do- | -do- |
| 31 | -do- | -do- | K-7 (3) | -do- | -do- | -do- | -do- | -do- | 478 |
| 32 | -do- | -do- | K-8 (3) | -do- | -do- | -do- | -do- | -do- | -do- |
| 33 | P-2 | M-2 (2) | -do- | B-4 (0.4) | S-1 (2) | -do- | -do- | -do- | -do- |

Table 12 (-continued)

| Example No. | Polymer No. | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 34 | P-6 | M-2 (6) | K-2 (3) | B-6 (0.4) | S-2 (2) | A-2 (2) | D-2 (2) | Z-2 (0.2) | 520 |
| 35 | -do- | -do- | K-1 (3) | -do- | -do- | -do- | - | - | -do- |
| 36 | P-7 | -do- | K-2 (3) | -do- | -do- | -do- | D-2 (2) | Z-1 (0.1) | -do- |
| 37 | -do- | M-1 (6) | K-1 (3) | B-5 (0.4) | S-1 (2) | -do- | - | - | -do- |
| 38 | P-8 | M-2 (6) | -do- | B-6 (0.4) | -do- | -do- | D-1 (2) | Z-1 (0.1) | -do- |
| 39 | -do- | M-1 (6) | K-6 (3) | B-2 (0.4) | S-2 (2) | A-1 (2) | D-2 (2) | Z-2 (0.1) | 572 |
| 40 | P-9 | M-2 (6) | K-1 (3) | B-6 (0.4) | S-1 (2) | A-2 (2) | -do- | Z-1 (0.1) | 520 |
| 41 | -do- | M-1 (6) | K-6 (3) | B-2 (0.4) | S-3 (3) | A-3 (2) | D-3 (2) | Z-2 (0.1) | 572 |

Table 12 (-continued)

| Example No. | Polymer No. | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 42 | P-10 | M-2 (6) | K-1 (3) | B-6 (0.4) | S-1 (2) | A-2 (2) | D-3 (2) | Z-2 (0.1) | 520 |
| 43 | -do- | M-3 (6) | K-7 (3) | B-3 (0.4) | S-2 (2) | A-3 (2) | D-2 (2) | Z-1 (0.1) | 572 |
| 44 | P-11 | -do- | K-4 (3) | B-4 (0.4) | -do- | -do- | D-1 (2) | -do- | -do- |
| 45 | -do- | M-1 (6) | K-8 (3) | B-5 (0.4) | S-1 (2) | A-2 (2) | D-2 (2) | Z-2 (0.1) | 520 |

Comparative Examples 1 to 16

The procedures of Examples 1 to 41 were repeated using the polymer and, if indicated, the compound having a terminal ethylenically unsaturated group, the oxime ester compound, the coumarin compound, the

aromatic amine compound, the mercapto-containing heterocyclic compound, the silane compound and the polymerization inhibitor in an amount as set forth in Table 13.

The results are set forth in Table 13.

Table 13

| Comparative Example No. | Polymer No. (100 parts by weight) | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Aromatic Heterocyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 1 | P-1 | M-1 (6) | - | - | S-1 (2) | A-1 (2) | D-1 (2) | Z-1 (0.1) | >1560*1 |
| 2 | -do- | M-2 (6) | - | - | S-2 (2) | A-2 (2) | D-2 (2) | -do- | -do- |
| 3 | -do- | M-3 (10) | - | - | S-3 (2) | A-3 (3) | D-3 (2) | -do- | -do- |
| 4 | -do- | M-2 (10) | - | - | S-2 (4) | A-2 (4) | D-2 (2) | -do- | -do- |
| 5 | -do- | M-2 (6) | K-1 (3) | - | S-1 (2) | A-2 (2) | -do- | -do- | -do- |
| 6 | -do- | M-2 (6) | K-2 (3) | - | -do- | -do- | -do- | -do- | -do- |
| 7 | -do- | -do- | K-3 (3) | - | -do- | -do- | -do- | -do- | -do- |
| 8 | -do- | -do- | K-1 (10) | - | -do- | -do- | -do- | -do- | -do- |

*1 Clear patterns could not be obtained even with an exposure dose of 1560 $mJ/cm^2$.

Table 13 (-continued)

| Comparative Example No. | Polymer No. (100 parts by (weight) | Compound having a terminal ethylenically unsaturated group (parts by weight) | Oxime Ester Compound (parts by weight) | Coumarin Compound (parts by weight) | Aromatic Amine Compound (parts by weight) | Mercapto-Containing Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 9 | P-1 | M-2 (6) | - | B-2 (0.4) | S-1 (2) | A-2 (2) | D-2 (2) | Z-1 (0.1) | >1560*1 |
| 10 | -do- | -do- | - | B-4 (0.4) | -do- | -do- | -do- | -do- | -do- |
| 11 | -do- | -do- | - | B-6 (0.4) | -do- | -do- | -do- | -do- | -do- |
| 12 | -do- | M-2 (10) | - | B-6 (0.6) | S-1 (4) | A-2 (4) | -do- | -do- | -do- |
| 13 | do- | - | K-4 (3) | B-1 (0.4) | S-1 (2) | A-2 (2) | -do- | -do- | -do- |
| 14 | -do- | - | K-5 (3) | B-2 (0.4) | -do- | -do- | -do- | -do- | -do- |
| 15 | -do- | - | K-6 (3) | B-3 (0.4) | -do- | -do- | -do- | -do- | -do- |
| 16 | -do- | - | K-6 (6) | B-1 (0.6) | S-1 (4) | A-2 (4) | -do- | -do- | -do- |

*1 Clear patterns could not be obtained even with an exposure dose of 1560 $mJ/cm^2$.

Comparative Examples 17 to 31

The procedures of Examples 1 to 41 were repeated using the polymer, the compound having a terminal ethylenically unsaturated group, the oxime ester compound, the photosensitizer instead of the coumarin

compound of the present invention, the aromatic amine compound, the mercapto-containing heterocyclic compound, the silane compound and the polymerization inhibitor an amount as set forth in Table 14.

The results are set forth in Table 14.

Table 14

| Comparative Example No. | Polymer No. (100 parts by weight) | Compound having a terminal ethylenically unsaturated group (parts by weight) | Oxime Ester Compound (parts by weight) | Photosensitizer (parts by weight) | Aromatic Amine Compound (parts by weight) | Mercapto-Containing Aromatic Heterocyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 17 | P-4 | M-1 (6) | K-2 (3) | B-7*1 (0.4) | S-3 (2) | A-3 (2) | D-2 (2) | Z-3 (0.1) | 1050 |
| 18 | -do- | -do- | -do- | -do- | S-2 (2) | -do- | D-4 (2) | -do- | -do- |
| 19 | P-1 | -do- | K-6 (3) | -do- | -do- | A-1 (2) | D-2 (2) | Z-1 (0.1) | -do- |
| 20 | P-4 | -do- | K-2 (3) | B-8*2 (0.4) | -do- | -do- | D-4 (2) | -do- | -do- |
| 21 | P-5 | -do- | K-3 (3) | -do- | -do- | -do- | -do- | Z-2 (0.1) | -do- |
| 22 | P-6 | -do- | K-6 (3) | -do- | S-3 (2) | A-3 (2) | D-2 (2) | -do- | -do- |
| 23 | P-7 | M-2 (6) | K-1 (3) | B-9*3 (0.4) | S-1 (2) | A-2 (2) | D-1 (2) | -do- (0.1) | 1200 |
| 24 | P-4 | M-1 (6) | K-5 (3) | -do- | S-2 (2) | A-1 (2) | D-4 (2) | Z-3 (0.1) | 1200 |

*1 B-7 : 7-Diethylamino-3-acetylcoumarin
*2 B-8 : 7-Dimethylamino-3-benzoylcoumarin
*3 B-9 : 7-Diethylamino-4-methylcoumarin

Table 14 (-continued)

| Comparative Example No. | Polymer No. (100 parts by weight) | Compound having a terminal ethylenically unsaturated group (parts by weight) | Oxime Ester Compound (parts by weight) | Photosensitizer (parts by weight) | Aromatic Amine Compound (parts by weight) | Mercapto-Containing Aromatic Hetero-cyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 25 | P-8 | M-1 (6) | K-6 (3) | B-9*2 (0.4) | S-3 (2) | A-3 (2) | D-2 (2) | Z-3 (0.1) | 1200 |
| 26 | P-9 | M-2 (6) | K-1 (3) | B-10*3 (0.4) | S-1 (2) | A-2 (2) | D-4 (2) | -do- | >1560*1 |
| 27 | P-2 | -do- | K-7 (3) | -do- | S-2 (2) | -do- | D-3 (2) | Z-2 (0.1) | -do- |
| 28 | P-9 | -do- | -do- | B-11*4 (0.4) | S-1 (2) | -do- | D-2 (2) | -do- | -do- |
| 29 | P-4 | -do- | K-8 (3) | -do- | -do- | -do- | D-1 (2) | Z-3 (0.1) | -do- |
| 30 | P-6 | -do- | K-1 (3) | B-12*5 (0.4) | -do- | -do- | D-2 (2) | -do- | 1200 |
| 31 | P-7 | M-1 (6) | K-6 (3) | -do- | S-2 (2) | A-1 (2) | D-4 (2) | Z-1 (0.1) | -do- |

*1 Clear patterns could not be obtained even with an exposure dose of 1560 $mJ/cm^2$.
*2 B-9 : 7-Diethylamino-4-methylcoumarin
*3 B-10 : 4,4'-Bis(diethylamino)benzophenone
*4 B-11 : Michler's ketone
*5 B-12 : 3,3'-Carbonylbis(7-diethylaminocoumarin)

Comparative Examples 32 to 37

The procedures of Examples 1 to 41 were repeated using the polymer, the compound having a terminal ethylenically unsaturated group, the photopolymerization initiator instead of the oxime ester compound of

the present invention, the coumarine compound, the aromatic amine compound, the mercapto-containing heterocyclic compound, the silane compound and the polymerization inibitor in an amount as set forth in Table 15.

The results are shown set forth in Table 15.

Table 15

| Comparative Example No. | Polymer No. (100 parts by weight) | Compound having a terminal ethylenically unsaturated group (parts by weight) | Photopolymerization Initiator (parts by weight) | Coumarin Compound (parts by weight) | Aromatic Amine Compound (parts by weight) | Mercapto-Containing Aromatic Heterocyclic Compound (parts by weight) | Silane Compound (parts by weight) | Polymerization Inhibitor (parts by weight) | Photosensitivity ($mJ/cm^2$) |
|---|---|---|---|---|---|---|---|---|---|
| 32 | P-1 | M-2 (6) | K-9*2 (3) | B-3 (0.4) | S-1 (2) | A-2 (2) | D-3 (2) | Z-1 (0.1) | >1560*1 |
| 33 | -do- | -do- | K-10*3 (3) | -do- | -do- | -do- | -do- | -do- | -do- |
| 34 | -do- | -do- | K-11*4 (3) | -do- | -do- | -do- | -do- | -do- | -do- |
| 35 | -do- | -do- | K-12*5 (3) | -do- | -do- | -do- | -do- | -do- | -do- |
| 36 | -do- | -do- | K-13*6 (3) | -do- | -do- | -do- | -do- | -do- | -do- |
| 37 | -do- | -do- | K-14*7 (3) | -do- | -do- | -do- | -do- | -do- | -do- |

*1 Clear patterns could not be obtained even with an exposure dose of 1560 $mJ/cm^2$.
*2 K-9 : Benzophenone *3 K-10 : Benzil * K-11 : Benzoin isobutylether
*5 K-12 : Benzyldimethylketal
*6 K-13 : 1-Phenyl-1,2-propanedione-2-(O-ethoxycarbonyl)oxime
*7 K-14 : 1,2-Diphenyl-1,2-ethanedione-2-(O-benzoyl)oxime

## Claims

**1.** A photosensitive composition comprising:

(a) a polymer having recurring units represented by the formula

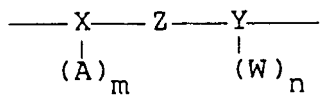

[I]

wherein

| | |
|---|---|
| X | is a (2 + m) valent $C_{6-30}$ carbocyclic group or heterocyclic group ; |
| Y | is a (2 + n) valent $C_{6-30}$ carbocyclic group or heterocyclic group ; |
| Z | is |

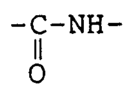 , 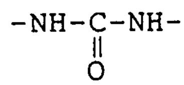

or

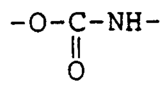 ;

| | |
|---|---|
| A | is -COOR* or $-COO^{\ominus}R^{**\oplus}$ wherein each of R* and R** is a group having a carbon-carbon double bond ; |
| W | is a group capable of reacting with the carbonyl group of A to form a ring on heating , selected from $-NH_2$ and |

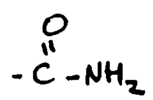 ;

| | |
|---|---|
| A and W | are arranged in ortho- or peri-position to z ; |
| m | is 1 or 2 ; and |
| n | is 0, 1 or 2 , |

(b) 1 to 20 % by weight, based on the weight of polymer (a), of a compound having a terminal ethylenically unsaturated group ;

(c) 0.1 to 20 % by weight, based on the weight of polymer (a), of an oxime ester compound represented by the formula

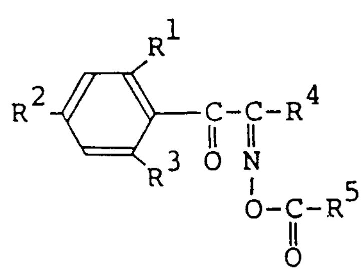

[II]

wherein

each of $R^1$, $R^2$ and $R^3$ is a hydrogen atom, a $C_{1-6}$ alkyl group, a $C_{1-6}$ alkoxy group or a nitro

group;

$R^4$ is a $C_{7-11}$ aromatic acyl group, a $C_{2-7}$ aliphatic acyl group, a $C_{2-7}$ alkoxycarbonyl group, a $C_{6-10}$ aromatic sulfonyl group or a $C_{1-6}$ aliphatic sulfonyl group ; and

$R_5$ is a $C_{1-6}$ alkyl group, a $C_{1-6}$ alkoxy group, a $C_{6-10}$ aromatic group or a $C_{6-10}$ aryloxy group ; and

(d) 0.01 to 10 % by weight, based on the weight of polymer (a), of a coumarin compound represented by the formula

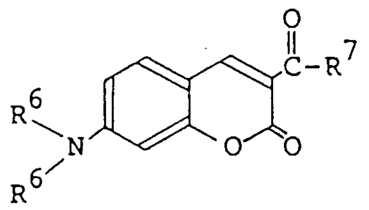

[III]

wherein

$R^6$ is a methyl group or an ethyl group ; and

$R^7$ is a $C_{1-7}$ alkoxy group.

**2.** A photosensitive composition of Claim 1 additionally comprising at most 10 % by weight, based on the weight of polymer (a), of an aromatic compound represented by the formula

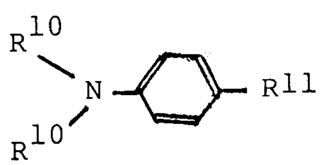

wherein

$R^{10}$ is a $C_{1-3}$ alkyl group, a $C_{1-3}$ hydroxyalkyl group or a morpholino group; and

$R^{11}$ is a $C_{1-3}$ alkyl group, a $C_{2-5}$ alkylcarbonyl group or a $C_{7-10}$ arylcarbonyl group.

**3.** A photosensitive composition of claim 1 or 2 further comprising at most 10 % by weight, based on the weight of polymer (a), of a mercapto-containing aromatic heterocyclic compound.

**4.** A photosensitive composition of claims 1-3 additionally comprising 0.05 to 10 % by weight, based on the weight of polymer (a), of a silane compound represented by the formula

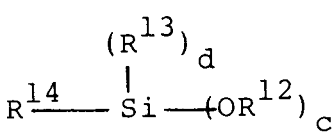

wherein

$R^{12}$ and $R^{13}$ each is a $C_{1-6}$ alkyl group;

$R^{14}$ is a hydrocarbon group which may have an oxygen atom, a nitrogen atom or a sulfur atom; and

c is 3 and d is zero or

c is 2 and d is one.

5. A photosensitive composition of claims 1-4 additionally comprising at most 5 % by weight, based on the weight of polymer (a), of a polymerization inhibitor.

6. A photosensitive composition of claim 1-5, wherein X in formula [I] is a group selected from the group consisting of a tri- or tetra-valent benzene ring, a tri- or tetra-valent condensed polycyclic ring, a tri- or tetra-valent heterocyclic ring and a group represented by the formula

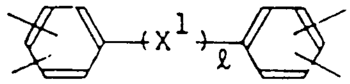

[Ia]

wherein
ℓ is zero or one ; and
$X^1$ is

$-(CH_2)_\ell-$ , 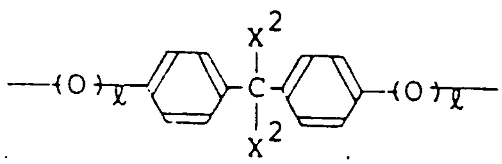 .

wherein
ℓ is zero or one,

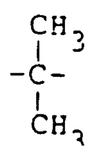 , 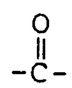 ,

-S-,

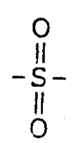 ,

-O- or

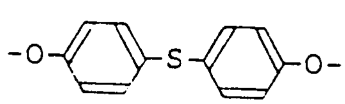 ;

and
$X^2$ is $-CH_3$ or $-CF_3$.

7. A photosensitive composition of claims 1-6, wherein Y in formula [I] is a group selected from the groups consisting of a di-, tri- or tetra-valent $C_{10-18}$ condensed polycyclic ring, a di-, tri- or tetra-valent heterocyclic ring and groups represented by the formulae

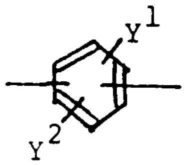

[Ib]

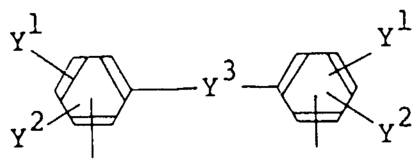

[Ic]

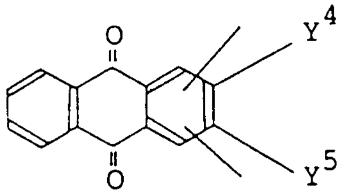

[Id]

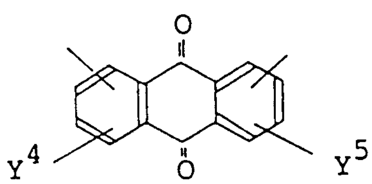

[Ie]

and

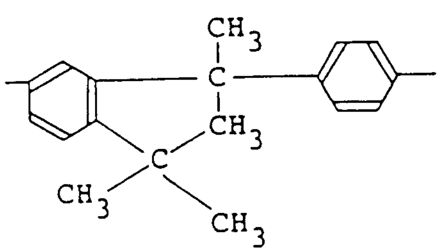

[If]

wherein

$Y^1$ and $Y^2$ each is a hydrogen atom, $-CH_3$, $-C_2H_5$, $-CH(CH_3)_2$, $-OCH_3$, $-COOH$, $-NO_2$, $-CONH_2$, $-NH_2$, a halogen atom or $-SO_3H$ ;

$Y^3$ is

$$-(CH_2)_p-$$

wherein p is zero or one,

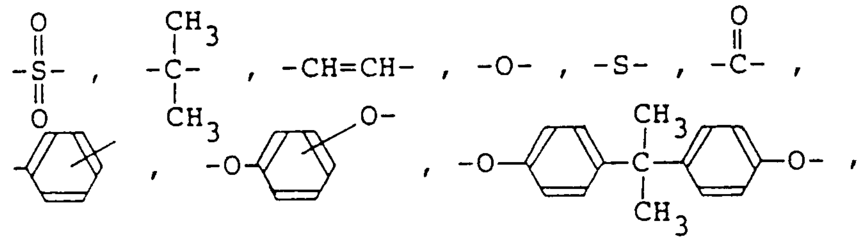

, -CH=CH- , -O- , -S- ,

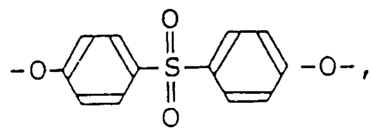 , 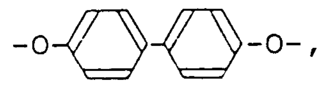 ,

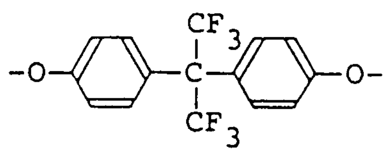 , 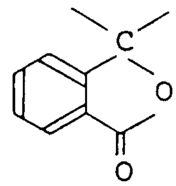 ,

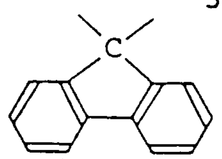 or 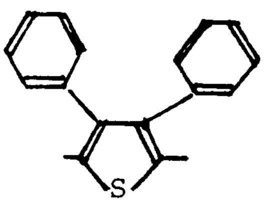

$Y^4$ and $Y^5$ each is a hydrogen atom, -CN, a halogen atom, $-CH_3$, $-OCH_3$, $-SO_3H$, $-NH_2$, -COOH or $-CONH_2$.

**8.** A photosensitive composition of claims 1-7, wherein R* in -COOR* of A in formula [I] is a group selected from the group consisting of groups represented by the formulae

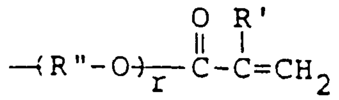

[Ig]

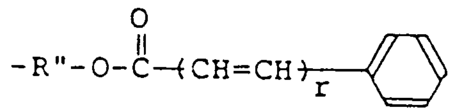

[Ih]

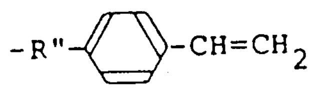

[Ii]

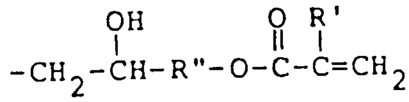

[Ij]

$-R''-CH=CH_2$ [Ik]

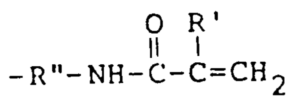

[Iℓ]

wherein

R' is a hydrogen atom or a methyl group;

R'' is a $C_{1-3}$ alkylene group; and

r is one or two.

**9.** A photosensitive composition of claims 1-7, wherein $R^{**\oplus}$ in $-COO^{\ominus}R^{**\oplus}$ of A in formula [I] is a group represented by the formula

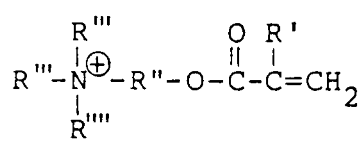

[Im]

wherein

R' and R'''' each is a hydrogen atom or a methyl group

R'' is a $C_{1-3}$ alkylene group; and

R''' is a methyl group or an ethyl group.

**10.** A photosensitive composition of claims 1-9, wherein the terminal ethylenically unsaturated group of compound (b) is represented by the formula

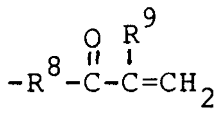

[IV]

wherein

- $R^8$ is -O- or -NH-; and
- $R^9$ is a hydrogen atom or a methyl group.

**11.** A photosensitive composition of claims 1-10, wherein the compound having a terminal ethylenically unsaturated group (b) has a molecular weight of 60 to 1,000.

**12.** A photosensitive composition of claims 1-11, wherein in the oxime ester compound (c) of formula [II], $R^1$, $R^2$ and $R^3$ each is a hydrogen atom, a methyl group, an ethyl group, a methoxy group, an ethoxy group or a nitro group; $R^4$ is a benzoyl group, a toluoyl group, an acetyl group, a propionyl group, an ethoxycarbonyl group, a benzenesulfonyl group, a toluenesulfonyl group, a methanesulfonyl group or an ethanesulfonyl group; and $R^5$ is an ethyl group, a butyl group, a methoxy group, an ethoxy group, a phenyl group, a tolyl group or a phenoxy group.

**13.** A photosensitive composition of claims 1-12, wherein the coumarin compound is a compound represented by the formula

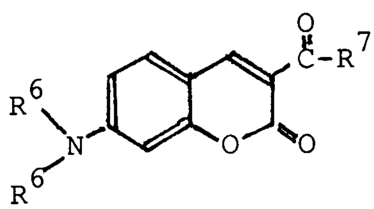

[III]

wherein

- $R^6$ is a methyl group or an ethyl group; and
- $R^7$ is a methoxy group, an ethoxy group, an n-propoxy group, an isopropoxy group, an n-butoxy group, an isobutoxy group, a tert-butoxy group or a benzyloxy group.

**14.** Method of producing a pattern wherein a photosensitive composition according to any of claims 1-13 is coated on a substrate, whereafter the photosenstive layer thus formed is exposed patternwise to actinic radiation, is developed in order to remove the unexposed portions, and is subjected to a heat treatment.

**15.** Method according to claim 14 wherein the photosensitive layer is exposed patternwise to actinic radiation having a wave-length of 436 nm.

**Patentansprüche**

**1.** Lichtempfindliche Zusammensetzung, enthaltend
(a) ein Polymeres mit wiederkehrenden Einheiten, die durch die Formel

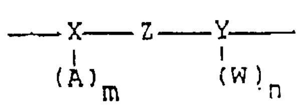

. [I]

dargestellt sind,
worin

- X eine (2 + m)-wertige $C_{6-30}$-carbocyclische Gruppe oder -heterocyclische Gruppe ist,
- Y eine (2 + n)-wertige $C_{6-30}$-carbocyclische Gruppe oder -heterocyclische Gruppe ist,

Z

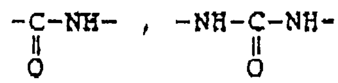

oder

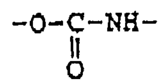

ist

A für -COOR* oder $-COO^{\ominus}R^{**\oplus}$ steht, wobei jedes von R* und R** eine Gruppe mit einer Kohlenstoff-Kohlenstoff-Doppelbindung ist,

W eine unter $-NH_2$ und $-CO-NH_2$ ausgewählte Gruppe ist, die zur Reaktion mit der Carbonylgruppe von A unter Ringbildung beim Erhitzen befähigt ist,

A und W in ortho- oder peri-Stellung gegenüber Z angeordnet sind,

m 1 oder 2 ist und

n 0, 1 oder 2 ist,

(b) 1 bis 20 Gew.%, bezogen auf das Gewicht des Polymeren (a), einer Verbindung mit einer endständigen ethylenisch ungesättigten Gruppe,

(c) 0,1 bis 20 Gew.%, bezogen auf das Gewicht des Polymeren (a), einer Oximesterverbindung der Formel

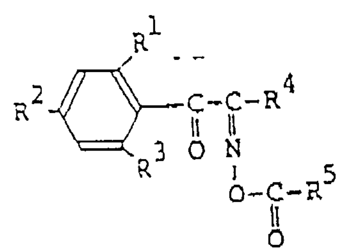

[II]

worin

jedes von $R^1$, $R^2$ und $R^3$ ein Wasserstoffatom, eine $C_{1-6}$-Alkylgruppe, eine $C_{1-6}$-Alkoxygruppe oder eine Nitrogruppe ist,

$R^4$ eine aromatische $C_{7-11}$-Acylgruppe, eine aliphatische $C_{2-7}$-Acylgruppe, eine $C_{2-7}$-Alkoxycarbonylgruppe, eine aromatische $C_{6-10}$-Sulfonylgruppe oder eine aliphatische $C_{1-6}$-Sulfonylgruppe ist, und

$R_5$ eine $C_{1-6}$-Alkylgruppe, eine $C_{1-6}$-Alkoxygruppe, eine $C_{6-10}$-aromatische Gruppe oder eine $C_{6-10}$-Aryloxygruppe ist, und

(d) 0,01 bis 10 Gew.%, bezogen auf das Gewicht des Polymeren (a), einer Cumarinverbindung der Formel

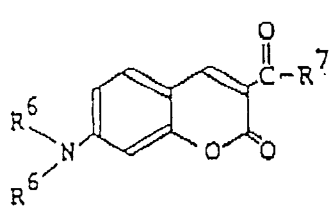

[III]

worin

$R^6$ eine Methylgruppe oder eine Ethylgruppe ist und

$R^7$ eine $C_{1-7}$-Alkoxygruppe ist.

2. Lichtempfindliche Zusammensetzung nach Anspruch 1, die zusätzlich höchstens 10 Gew.%, bezogen auf das Gewicht des Polymeren (a), einer aromatischen Verbindung der Formel

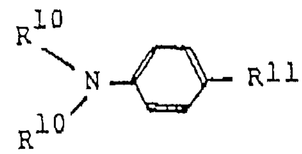

enthält,
worin

| | |
|---|---|
| $R^{10}$ | eine $C_{1-3}$-Alkylgruppe, eine $C_{1-3}$-Hydroxyalklgruppe oder eine Morpholinogruppe ist und |
| $R^{11}$ | eine $C_{1-3}$-Alkylgruppe, eine $C_{2-5}$-Alkylcarbonylgruppe oder eine $C_{7-10}$-Arylcarbonylgruppe ist. |

3. Lichtempfindliche Zusammensetzung nach Anspruch 1 oder 2, die zusätzlich höchstens 10 Gew.%, bezogen auf das Gewicht des Polymeren (a), einer Mercaptogruppe enthaltenden aromatischen heterocyclischen Verbindung enthält.

4. Lichtempfindliche Zusammensetzung nach Ansprüchen 1 bis 3, die zusätzlich 0,05 bis 10 Gew.%, bezogen auf das Gewicht des Polymeren (a), einer Silanverbindung der Formel

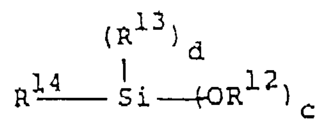

enthält,
worin

| | |
|---|---|
| $R^{12}$ und $R^{13}$ | jeweils eine $C_{1-6}$-Alkylgruppe bedeuten, |
| $R^{14}$ | eine Kohlenwasserstoffgruppe, die ein Sauerstoffatom, ein Stickstoffatom oder ein Schwefelatom enthalten kann, ist und |
| c | 3 und d 0 ist oder |
| c | 2 ist und d 1 ist. |

5. Lichtempfindliche Zusammensetzung nach Ansprüchen 1 bis 4, die zusätzlich höchstens 5 Gew.%, bezogen auf das Gewicht des Polymeren (a), eines Polymerisationsinhibitors enthält.

6. Lichtempfindliche Zusammensetzung nach Anspruch 1 bis 5, worin X in Formel [I] eine Gruppe ist, die aus der aus einem drei- oder vierwertigen Benzolring, einem drei- oder vierwertigen kondensierten polycyclischen Ring, einem drei- oder vierwertigen hetrocyclischen Ring und einer Gruppe der nachstehenden Formel [Ia] bestehenden Gruppe ausgewählt ist

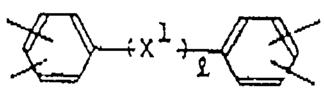

[Ia]

worin

| | |
|---|---|
| ℓ | 0 oder 1 ist und |
| $X^1$ | |

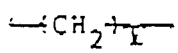 , 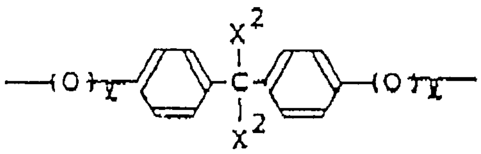

worin ℓ 0 oder 1 ist,

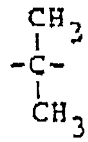 , 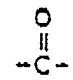 ,

-S- ,
-O- '

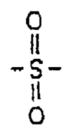

oder

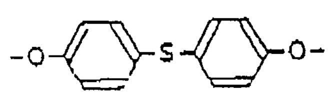

bedeutet, und

$X^2$ $-CH_3$ oder $-CF_3$ ist.

**7.** Lichtempfindliche Zusammensetzung nach Ansprüchen 1 bis 6, wobei Y in Formel [I] eine Gruppe ist, die aus der aus einem zwei-, drei- oder vierwertigen kondensierten polycyclischen $C_{10-18}$-Ring, einem zwei-, drei- oder vierwertigen heterocyclischen Ring und durch die nachstehenden Formeln dargestellten Gruppen

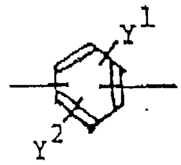

[Ib]

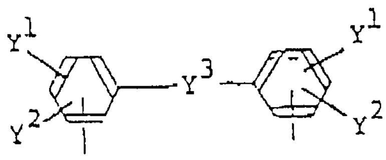

[Ic]

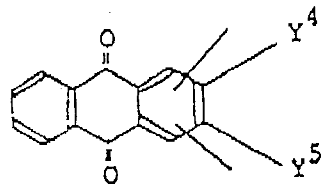

[Id]

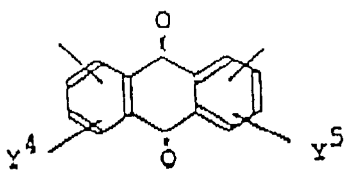

[Ie]

und

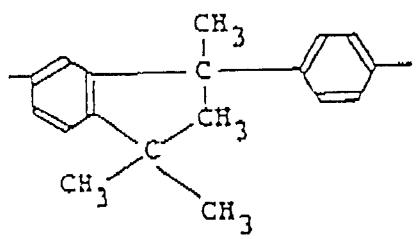

[If]

bestehenden Gruppe ausgewählt ist,
worin

- $Y^1$ und $Y^2$ jeweils ein Wasserstoffatom, $-CH_3$, $-C_2H_5$, $-CH(CH_3)_2$, $-OCH_3$, -COOH, $-NO_2$, $-CONH_2$, $-NH_2$, ein Halogenatom oder $-SO_3H$ bedeuten,
- $Y^3$ $-(CH_2)_p$-, worin p 0 oder 1 ist,

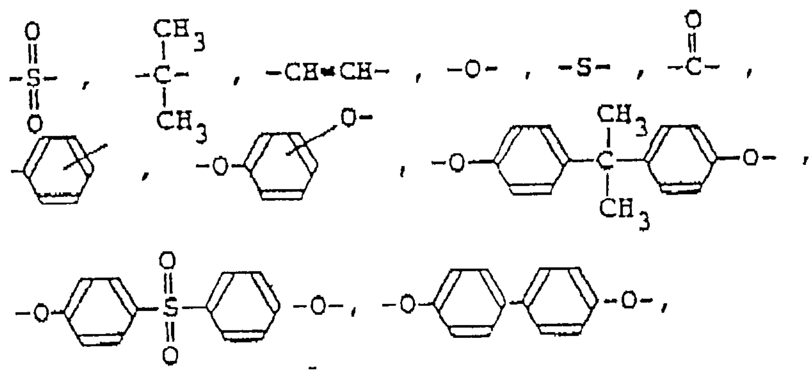

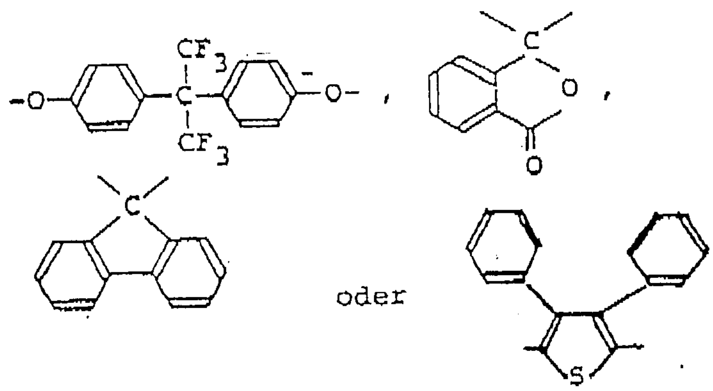

bedeutet,

$Y^4$ und $Y^5$ jeweils ein Wasserstoffatom, -CN, ein Halogenatom, $-CH_3$, $-OCH_3$, $-SO_3H$, $-NH_2$, -COOH oder $-CONH_2$ bedeuten.

8. Lichtempfindliche Zusammensetzung nach Ansprüchen 1 bis 7, wobei R* in -COOR* des Rests A in Formel [I] eine Gruppe ist, die unter den durch die nachstehenden Formeln dargestellten Gruppen ausgewählt ist

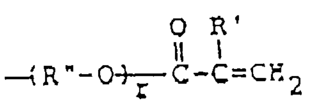

[Ig]

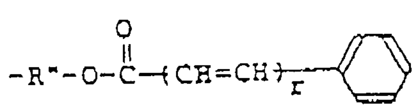

[Ih]

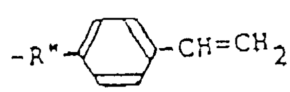

[Ii]

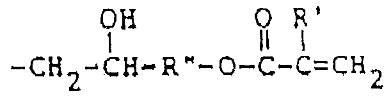 [Ij]

$-R''-CH=CH_2$ [Ik]

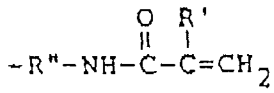 [Iℓ]

worin
- R' ein Wasserstoffatom oder eine Methylgruppe ist,
- R'' eine $C_{1-3}$-Alkylengruppe ist und
- r 1 oder 2 ist.

**9.** Lichtempfindliche Zusammensetzung nach Ansprüchen 1 bis 7, worin $R^{**\oplus}$ in $-COO^{\ominus}R^{**\oplus}$ der Gruppe A in Formel [I] eine durch die nachstehende Formel dargestellte Gruppe ist

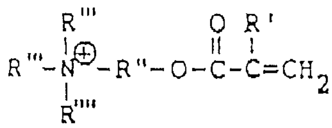 [Im]

worin
- R' und R'''' jeweils ein Wasserstoffatom oder eine Methylgruppe bedeuten,
- R'' eine $C_{1-3}$-Alkylengruppe ist und
- R''' eine Methylgruppe oder eine Ethylgruppe ist.

**10.** Lichtempfindliche Zusammensetzung nach Ansprüchen 1 bis 9, wobei die endständige ethylenisch ungesättigte Gruppe der Verbindung (b) durch die Formel

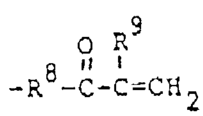 [IV]

dargestellt ist,
worin
- $R^8$ -O- oder -NH- ist und
- $R^9$ ein Wasserstoffatom oder eine Methylgruppe ist.

**11.** Lichtempfindliche Zusammensetzung nach Ansprüchen 1 bis 10, wobei die Verbindung mit einer endständigen ethylenisch ungesättigten Gruppe (b) ein Molekulargewicht von 60 bis 1000 hat.

**12.** Lichtempfindliche Zusammensetzung nach Ansprüchen 1 bis 11, wobei in der Oximesterverbindung (c) der Formel [II] $R^1$, $R^2$ und $R^3$ jeweils ein Wasserstoffatom, eine Methylgruppe, eine Ethylgruppe, eine Methoxygruppe, eine Ethoxygruppe oder ein Nitrogruppe bedeuten, $R^4$ eine Benzoylgruppe, eine Toluoylgruppe, eine Acetylgruppe, eine Propionylgruppe, eine Ethoxycarbonylgruppe, eine Benzolsulfonylgruppe, eine Toluolsulfonylgruppe, ein Methansulfonylgruppe oder eine Ethansulfonylgruppe ist und $R^5$ eine Ethylgruppe, eine Butylgruppe, eine Methoxygruppe, eine Ethoxygruppe, eine Phenylgruppe, eine Tolylgruppe oder eine Phenoxygruppe ist.

**13.** Lichtempfindliche Zusammensetzung nach Ansprüchen 1 bis 12, wobei die Cumarinverbindung eine durch die Formel

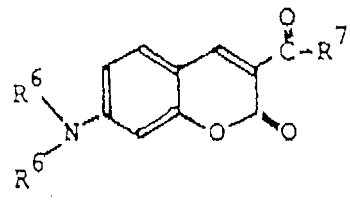

[III]

dargestellte Verbindung ist,
worin

$R^6$ eine Methylgruppe oder eine Ethylgruppe ist und
$R^7$ eine Methoxygruppe, eine Ethoxygruppe, eine n-Propoxygruppe, eine Isopropoxygruppe, eine n-Butoxygruppe, eine Isobutoxygruppe, eine tert-Butoxygruppe oder eine Benzyloxygruppe ist.

**14.** Verfahren zur Herstellung eines Musters, wobei eine lichtempfindliche Zusammensetzung nach einem der Ansprüche 1 bis 13 auf ein Substrat aufgetragen wird, wonach die so gebildete lichtempfindliche Schicht bildmäßig mit aktinischer Strahlung bestrahlt wird, zum Entfernen der unbelichteten Bereiche entwickelt wird und einer Wärmebehandlung unterworfen wird.

**15.** Verfahren nach Anspruch 14, wobei die lichtempfindliche Schicht bildmäßig mit aktinischer Strahlung einer Wellenlänge von 436 nm bestrahlt wird.

**Revendications**

**1.** Composition photosensible comprenant :
a) un polymère ayant des motifs répétitifs représentés par la formule

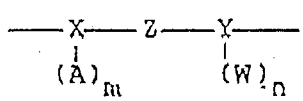

[I]

dans laquelle

X est un groupe carbocyclique ayant de 6 à 30 atomes de carbone ou un groupe hétérocyclique (2 + m) valent ;
Y est un groupe carbocyclique ayant de 6 à 30 atomes de carbone ou un groupe hétérocyclique (2 + n) valent ;
Z est

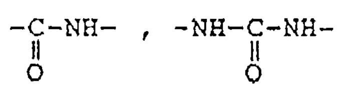

or

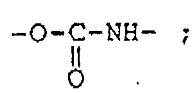

A est -COOR* ou-COO$^{\ominus}$R$^{**\oplus}$ dans lesquelles chacun de R* et R** est un groupe ayant une liaison double carbone-carbone ;
W est un groupe apte à réagir sur le carbonyle de A pour former un cycle par chauffage,

choisi parmi $-NH_2$ et

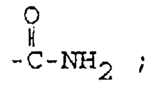

A et W sont en position ortho ou en position para par rapport à Z ;
m est un 1 ou 2 ; et
n est 0, 1 ou 2,

b) de 1 à 20 % du poids du polymère (a) d'un composé ayant un groupe d'extrémité à insaturation éthylénique ;

c) de 0,1 à 20 % du poids du polymère (a) d'un oxime ester représenté par la formule

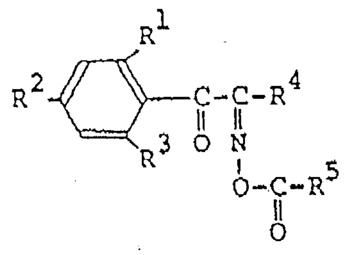

[II]

dans laquelle

chacun de $R^1$, $R^2$ et $R^3$ est un atome d'hydrogène, un groupe alcoyle ayant de 1 à 6 atomes de carbone, un groupe alcoxy ayant de 1 à 6 atomes de carbone ou un groupe nitro ;

$R^4$ est un groupe acyle aromatique ayant de 7 à 11 atomes de carbone, un groupe acyle aliphatique ayant de 2 à 7 atomes de carbone, un groupe alcoxycarbonyle ayant de 2 à 7 atomes de carbone, un groupe sulfonyle aromatique ayant de 6 à 10 atomes de carbone, un groupe sulfonyle aliphatique ayant de 1 à 6 atomes de carbone ;

$R^5$ est un groupe alcoyle ayant de 1 à 6 atomes de carbone, un groupe alcoxy ayant de 1 à 6 atomes de carbone, un groupe aromatique ayant de 6 à 10 atomes de carbone ou un groupe aryloxy ayant de 6 à 10 atomes de carbone ; et

(d) de 0,01 à 10 % du poids du polymère (a) d'une coumarine représentée par la formule

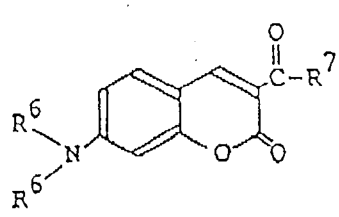

[III]

dans laquelle

$R^6$ est un groupe méthyle ou un groupe éthyle ;
$R^7$ est une groupe alcoxy ayant de 1 à 7 atomes de carbone.

**2.** Composition photosensible suivant la revendication 1, comprenant en outre au plus 10 % du poids du polymère (a) d'un composé aromatique représenté par la formule

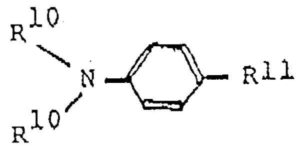

dans laquelle

- $R^{10}$ est un groupe alcoyle ayant de 1 à 3 atomes de carbone, un groupe hydroxy-alcoyle ayant de 1 à 3 atomes de carbone ou un groupe morpholino ; et
- $R^{11}$ est un groupe alcoyle ayant de 1 à 3 atomes de carbone, un groupe alcoylcarbonyle ayant de 2 à 5 atomes de carbone ou un groupe arylcarbonyle ayant de 7 à 10 atomes de carbone.

**3.** Composition photosensible suivant la revendication 1 ou 2, comprenant en outre au plus 10 % du poids du polymère (a) d'un composé hétérocyclique aromatique contenant un groupe thiol.

**4.** Composition photosensible suivant les revendications 1 à 3, comprenant en outre de 0,05 à 10 % du poids du polymère (a) d'un silane de formule

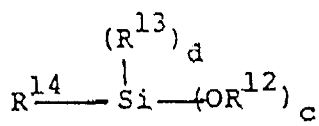

dans laquelle

- $R^{12}$ et $R^{13}$ sont chacun un groupe alcoyle ayant de 1 à 6 atomes de carbone;
- $R^{14}$ est un groupe hydrocarboné qui peut avoir un atome d'oxygène, un atome d'azote ou un atome de soufre ;
- c est 3 et d est 0 ou
- c est 2 et d est 1.

**5.** Composition photosensible suivant les revendications 1 à 4, comprenant en outre au plus 5 % du poids du polymère (a) d'un inhibiteur de polymérisation.

**6.** Composition photosensible suivant les revendications 1 à 5, dans laquelle X à la formule [I] est un groupe choisi parmi un cycle benzénique trivalent ou tétravalent, un cycle polycyclique condensé trivalent ou tétravalent, un cyle hétérocyclique trivalent ou tétravalent et un groupe représenté par la formule

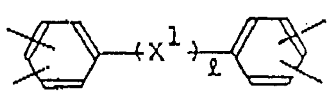

[Ia]

dans laquelle l est 0 ou 1 ; et

- $X^1$ is

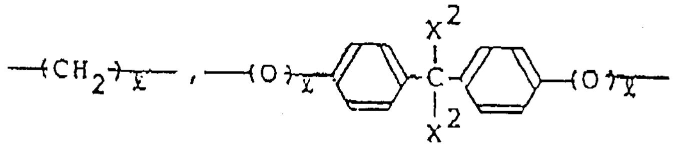

dans laquelle l est 0 ou 1,

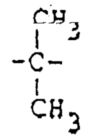 , 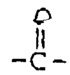 ,

-S- ,

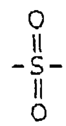 ,

-O- ou

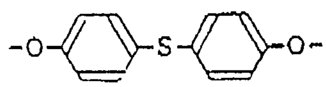 ;

et

$X^2$ is $-CH_3$ ou $-CF_3$.

**7.** Composition photosensible suivant les revendications 1 à 6, dans laquelle Y a la formule [I] est une groupe choisi parmi les cycles polycycliques condensés et ayant de 10 à 18 atomes de carbone divalents, trivalents ou tétravalents les cycles hétérocycliques divalents trivalents ou tétravalents et les groupes représentés par les formules

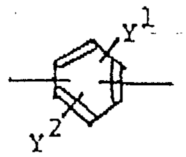

[Ib]

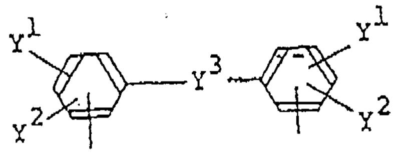

[Ic]

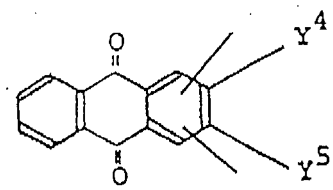

[Id]

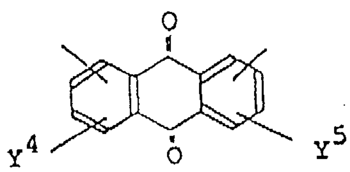

[Ie]

et

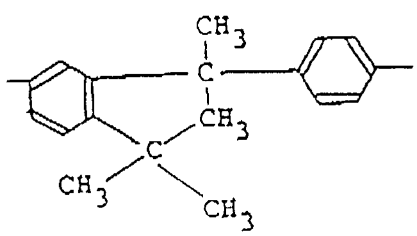

[If]

dans lesquelles

- $Y^1$ et $Y^2$ sont chacun un atome d'hydrogène - $CH_3$, $-C_2H^5$, $-CH(CH_3)_2$, $-OCH_3$, -COOH, $-NO_2$, -$CONH_2$, $-NH_2$, un atome d'halogène ou $-SO_3H$ ;
- $Y^3$ est

$$-(CH_2)_p-$$

dans laquelle p est 0 ou 1,

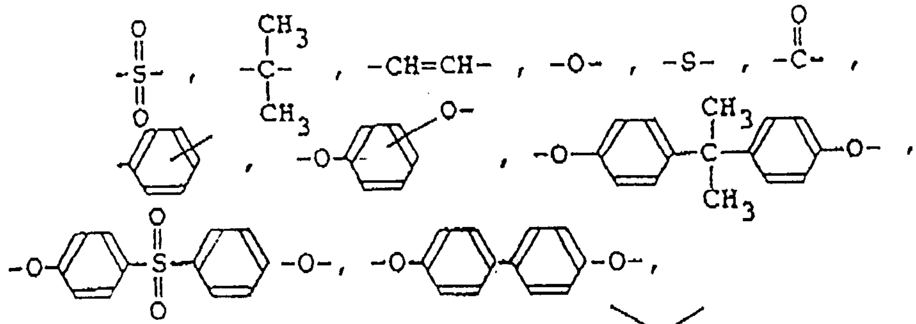

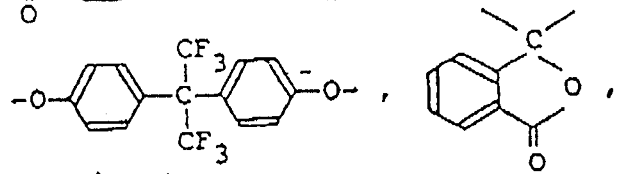

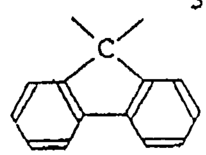

ou

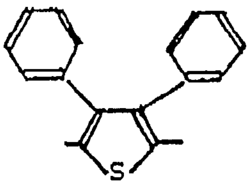

Y⁴ et Y⁵ sont chacun un atome hydrogène -CN, un atome halogène $-CH_3$, $-OCH_3$, $-SO_3H$, $-NH_2$, -COOH ou $-CONH_2$.

8. Composition photosensible suivant les revendications 1 à 7, dans laquelle R* dans -COOR* de A à la formule [I] est un groupe choisi parmi ceux représentés par les formules

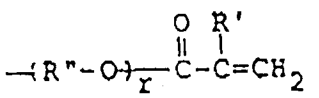 [Ig]

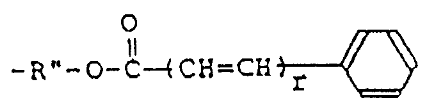 [Ih]

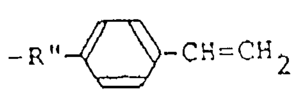 [Ii]

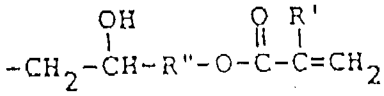 [Ij]

$-R''-CH=CH_2$ [Ik]

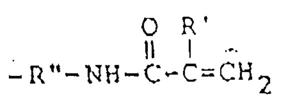 [Iℓ]

dans lesquelles

R' est un atome d'hydrogène ou un groupe méthyle ;

R'' est un groupe alcoylène ayant de 1 à 3 atomes de carbone ; et
r est un 1 ou 2.

**9.** Composition photosensible suivant les revendications 1 à 7, dans laquelle $R^{**\oplus}$ dans $-COO^{\ominus}R^{**\oplus}$ de A à la formule [I] est un groupe représenté par la formule

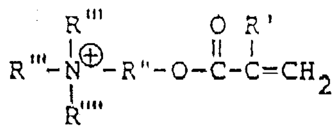

[Im]

dans laquelle
R' et R'''' sont chacun un atome d'hydrogène ou un groupe méthyle
R'' est un groupe alcoylène ayant de 1 à 3 atomes de carbone ; et
R''' est un groupe méthyle ou un groupe éthyle.

**10.** Composition photosensible suivant les revendications 1 à 9, dans laquelle le groupe d'extrémité à insaturation éthylénique du composé (b) est représenté par la formule

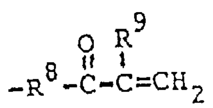

[IV]

dans laquelle
$R^8$ est -O- ou -NH- ; et
$R^9$ est un atome d'hydrogène ou un groupe méthyle.

**11.** Composition photosensible suivant les revendications 1 à 10, dans laquelle le composé ayant un groupe d'extrémité à insaturation éthylénique a une masse moléculaire de 60 à 1000.

**12.** Composition photosensible suivant les revendications 1 à 11, dans laquelle dans l'ester oxime (c) de formule [II], $R^1$, $R^2$ et $R^3$ sont chacun un atome d'hydrogène, un groupe méthyle, un groupe éthyle, un groupe méthoxy, un groupe éthoxy ou un groupe nitro, $R^4$ est un groupe benzoyle, un groupe toluoyle, un groupe acétyle, un groupe propionyle, un groupe éthoxycarbonyle, un groupe benzènesulfonyle, un groupe toluènensulfonyle, un groupe méthanesulfonyle, un groupe éthanesulfonyle ; et $R^5$ est un groupe éthyle, un groupe butyle, un groupe méthoxy, un groupe éthoxy, un groupe phényle, un groupe tolyle ou un groupe phénoxy.

**13.** Composition photosensible suivant les revendications 1 à 12, dans laquelle la coumarine est un composé représenté par la formule

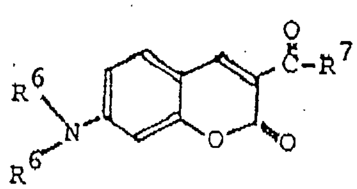

[III]

dans laquelle
$R^6$ est un groupe méthyle ou un groupe éthyle; et
$R^7$ est un groupe méthoxy, un groupe éthoxy, un groupe n-propoxy, an groupe isopropoxy, un groupe n-butoxy, un groupe isobutoxy, un groupe tert-butoxy ou un groupe benzyloxy.

**14.** Procédé de production d'un motif qui consiste à appliquer une composition photosensible suivant l'une quelconque des revendications 1 à 13 à un substrat, puis à exposer, de manière à former un motif, la couche photosensible ainsi formée à un rayonnement actinique, à la développer afin d'éliminer les parties non exposées et à la soumettre à un traitement thermique.

**15.** Procédé suivant la revendication 14, qui consiste à exposer la couche photosensible, de manière à former un motif, à un rayonnement actinique d'une longueur d'onde de 436 nm.